Europäisches Patentamt

European Patent Office

Office européen des brevets

(19)

(11) **EP 0 883 900 B1**

(12) **FASCICULE DE BREVET EUROPEEN**

(45) Date de publication et mention
de la délivrance du brevet:
**08.06.2005 Bulletin 2005/23**

(51) Int Cl.⁷: **H01L 27/146**, H04N 3/15

(21) Numéro de dépôt: **96942394.6**

(86) Numéro de dépôt international:
**PCT/FR1996/001990**

(22) Date de dépôt: **12.12.1996**

(87) Numéro de publication internationale:
**WO 1998/026455 (18.06.1998 Gazette 1998/24)**

(54) **DISPOSITIF ET PROCEDE DE LECTURE D'UNE MATRICE DE DETECTEURS PHOTONIQUES**

VORRICHTUNG UND AUSLESEVERFAHREN EINER MATRIX VON LICHTDETEKTOREN

DEVICE AND PROCESS FOR READING A PHOTONIC DETECTOR MATRIX

(84) Etats contractants désignés:
**DE GB IT**

(43) Date de publication de la demande:
**16.12.1998 Bulletin 1998/51**

(73) Titulaire: **COMMISSARIAT A L'ENERGIE
ATOMIQUE
75015 Paris (FR)**

(72) Inventeurs:
• **MARION, Dominique
F-38000 Grenoble (FR)**
• **MOTTIN, Eric
F-38000 Grenoble (FR)**
• **PANTIGNY, Philippe
F-38640 Claix (FR)**

(74) Mandataire: **Poulin, Gérard et al
BREVALEX
3, rue du docteur Lancereaux
75008 Paris (FR)**

(56) Documents cités:
**US-A- 4 942 474        US-A- 5 184 018**

• **PROCEEDINGS OF THE INTERNATIONAL
ELECTRON DEVICES MEETING, WASHINGTON,
DEC. 5 - 8, 1993, 5 décembre 1993, INSTITUTE
OF ELECTRICAL AND ELECTRONICS
ENGINEERS, pages 583-586, XP000481685
MENDIS S K ET AL: "128 X 128 CMOS ACTIVE
PIXEL IMAGE SENSOR FOR HIGHLY
INTEGRATED IMAGING SYSTEMS"**
• **JAPANESE JOURNAL OF APPLIED PHYSICS,
vol. 32, no. 1A, PART 01, 1 janvier 1993, pages
198-204, XP000413975 FUJIEDA I ET AL: "HIGH
SENSITIVITY READOUT OF 2D A-SI IMAGE
SENSORS"**
• **PROCEEDINGS OF THE SPIE, vol. 819, 1 janvier
1987, pages 224-231, XP000564819
BALLINGALL R A ET AL: "PRACTICAL DESIGN
CONSIDERATIONS IN ACHIEVING HIGH
PERFORMANCE FROM INFRARED HYBRID
FOCAL PLANE ARRAYS" cité dans la demande**
• **PROCEEDINGS OF THE CONFERENCE OF
ELECTRICAL AND ELECTRONICS ENGINEE IN
ISRAEL, TEL AVIV, MAR. 7 - 9, 1989, no. CONF.
16, 7 mars 1989, INSTITUTE OF ELECTRICAL
AND ELECTRONICS ENGINEERS, pages 1-4,
XP000077575 KEPTEN A ET AL: "INSB
MONOLITHIC UNIT CELL FOR IR IMAGING"**

**Description**

Domaine technique

La présente invention concerne un dispositif de lecture d'une matrice de détecteurs photoniques.

Etat de la technique antérieure

Les dispositifs de détection photonique concernés par l'invention sont de deux types :

- quantiques ;
- thermiques.

Dans les détecteurs quantiques, les photons reçus par le détecteur sont convertis en électrons et/ou trous selon le principe de la détection intrinsèque (transition bande de valence à bande de conduction directe) ou extrinsèque (transition entre niveau intermédiaire et bande de conduction). Les détecteurs quantiques peuvent être regroupés en deux catégories :

- les détecteurs photovoltaïques dont l'intensité du courant varie en fonction du flux incident;
- les détecteurs photoconducteurs dont la résistance varie en fonction du flux incident.

Les détecteurs thermiques peuvent être regroupés en deux catégories :

- les détecteurs bolométriques résistifs, la résistance varie en fonction de l'énergie du rayonnement incident ;
- les détecteurs à diodes, dont l'intensité du courant varie en fonction du flux incident.

Les détecteurs quantiques et les détecteurs thermiques peuvent être chacun assimilé à un générateur de courant, plus ou moins idéal, qui délivre un courant dont l'intensité varie en fonction du flux incident, moyennant que ces détecteurs soient convenablement polarisés.

Dans des caméras intéressantes pour l'invention, les images sont faites soit à partir de barrettes de détecteurs, autrement dit des détecteurs implantés à un pas régulier dans une seule direction, qui doivent être balayées, soit à partir de mosaïques ou matrices, autrement dit des détecteurs implantés de façon matricielle, qui ne sont pas balayées dans la plupart des cas.

Vu le nombre de détecteurs utilisés dans les caméras actuelles, et vu le pas des détecteurs, il est absolument nécessaire d'utiliser un circuit spécifique, que l'on désignera par la suite par circuit de lecture, pour conditionner le signal délivré par le détecteur et le multiplexer vers un nombre restreint de chaînes de traitement de l'information.

Chaque détecteur peut être réalisé soit directement sur le circuit de lecture, soit sur un autre circuit. Dans le premier cas on parle de composant monolithique et dans le deuxième de composant hybride car les détecteurs du circuit de détection sont interconnectés aux étages d'entrée du circuit de lecture par des technologies adaptées comme l'hybridation par billes.

L'invention porte sur une architecture de circuit de lecture particulièrement adaptée à la lecture de mosaïque de :

- détecteurs quantiques réalisés sur un autre substrat que celui du circuit de lecture et, par conséquent, hybridé à ce circuit de lecture ;
- détecteurs thermiques réalisés directement sur le circuit de lecture.

On va à présent décrire plusieurs circuits de lecture de l'art antérieur.

Circuits de lecture de type dispositifs à transfert de charges

Les circuits de lecture de type dispositifs à transfert de charges sont fabriqués dans des filières spécifiques permettant de réaliser des dispositifs à transfert de charges.

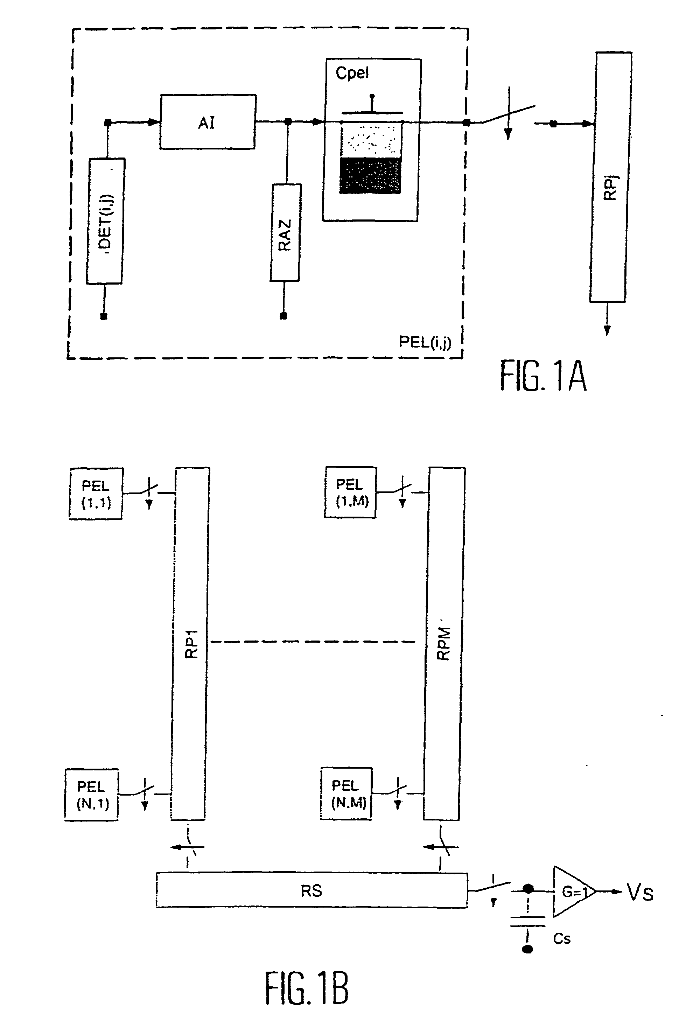

Le schéma de principe de ces circuits est donné sur les figures 1A et 1B.

On trouve dans chaque point élémentaire représenté sur la figure 1A :

- un interrupteur ou un dispositif d'adaptation d'impédance AI entre un détecteur et un condensateur MOS ;
- un condensateur MOS Cpel ("Conception de circuits intégrés MOS" aux éditions Eyrolles) dont le canal d'inversion est utilisé comme site de stockage ;
- un interrupteur qui permet de contrôler l'injection des charges stockées dans le point élémentaire dans le canal d'un registre à transfert de charges ;
- un dispositif de remise à zéro (RAZ) du site de stockage.

Le multiplexage des charges stockées dans les points élémentaires vers une ou des sorties se fait au moyen de deux types de registre à transfert de charges :

- les registres parallèles RPj qui muitipiexent les points élémentaires d'une colonne vers une entrée du registre série ;
- le (les) registre(s) séries RS qui multiplexent les charges venant des registres parallèles vers (les) l'étage(s) de sortie du circuit de lecture.

A chaque trame, le canal d'inversion du condensateur d'intégration est vidé de toute charge au moyen du dispositif de remise à zéro. Le courant débité par chaque détecteur de la mosaïque est alors intégré pendant le temps de pose dans le canal d'inversion du condensateur d'intégration.

La charge intégrée $Qpel_{ij}$ dans la capacité de stockage Cpel du point élémentaire PEL(i,j) est reliée à l'intensité $Id_{ij}$ du courant débité par le détecteur DET(i,j) et au temps de pose par la rotation :

$$Qpel_{ij} = Id_{ij} \times Tpose$$

Tout ou partie de la charge stockée dans chacun de ces condensateurs d'intégration est alors prélevée par différentes techniques et multiplexée au moyen de dispositifs à transfert de charges vers un (des) étage(s) de sortie. C'est dans l'étage de sortie que les charges sont converties en tension par injection dans une capacité convenablement polarisée. La tension aux bornes de ce condensateur est lue par un amplificateur de tension à très forte impédance d'entrée et à faible impédance de sortie.

L'expression de l'amplitude $\delta Vs_{ij}$ de l'impulsion de tension de sortie, correspondant à la lecture du point élémentaire PEL(i,j), est donnée par l'expression :

$$\delta Vs_{ij} = Aq \times Id_{ij} \times Tpose / Cs$$

où Cs est le facteur de conversion charge tension de l'étage de sortie et Aq le gain en charges du circuit.

Ces circuits de lecture présentent l'avantage d'avoir un temps de pose identique et synchrone pour tous les détecteurs.

En revanche, ils ne sont pas compatibles avec un adressage aléatoire des détecteurs, ce qui interdit de réaliser des sous-images.

Le dispositif de remise à zéro n'est absolument nécessaire que si l'intégralité de la charge intégrée ne peut être transférée dans le registre parallèle.

Ces circuits de lecture présentent enfin l'inconvénient majeur de devoir être réalisés dans des filières spécifiques dont la densité d'intégration est inférieure à celle des filières CMOS classiques alors que le pas des mosaïques de détecteurs se réduit fortement.

**Circuits de lecture de type suiveurs commutés**

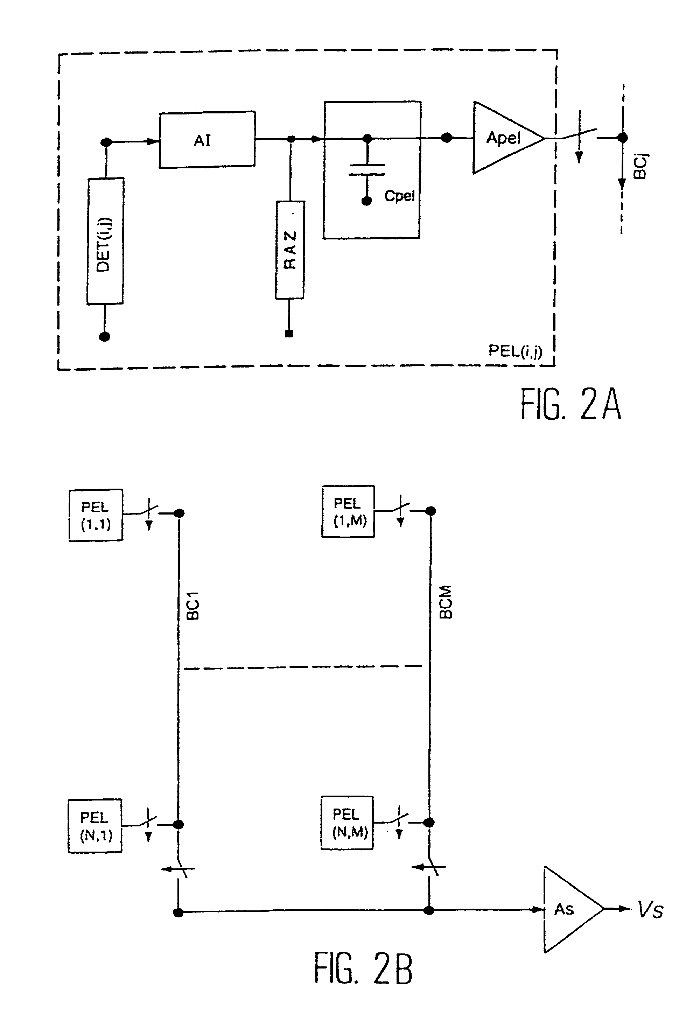

Pour des circuits de lecture de type suiveurs commutés décrits notamment dans les références [1], [2] et [3] citées en fin de description, un schéma de principe est donné sur les figures 2A et 2B.

On trouve au minimum dans chaque point élémentaire représenté sur la figure 2A :

- un interrupteur ou un dispositif d'adaptation d'impédance AI entre un détecteur DET(i,j) et un condensateur d'intégration ;
- un condensateur Cpel réalisé au moyen d'un transistor MOS dont la capacité grille-source permet de convertir le courant en tension par intégration ;
- un interrupteur de réinitialisation du condensateur d'intégration à chaque trame, réalisé au moyen de transistors MOS ;
- un amplificateur de tension Apel à forte impédance d'entrée qui permet de lire la tension aux bornes du condensateur d'intégration et d'attaquer à basse impédance un amplificateur de sortie ;
- un interrupteur qui permet de commuter la sortie de l'amplificateur du point élémentaire sur une connexion commune aux points élémentaires d'une même colonne, dite bus colonne BCj.

Le multiplexage des bus colonnes BCj vers un ou plusieurs amplificateurs de sortie As se fait au moyen d'interrupteurs implantés aux extrémités de chaque bus colonne.

A chaque trame, la tension aux bornes du condensateur d'intégration est tout d'abord réinitialisée au moyen de l'interrupteur de remise à zéro. Le courant du détecteur est alors intégré dans le condensateur d'intégration pendant une durée Tpose. A la fin du temps d'intégration, la sortie de l'amplificateur du point élémentaire est commutée sur le bus colonne et sur l'amplificateur de sortie au moyen des interrupteurs du point élémentaire et du multiplexeur ligne convenablement séquences.

L'expression de la variation de tension, $\delta Vpel_{ij}$, aux bornes du condensateur d'intégration du point élémentaire PEL(i,j) en fonction du courant, $Id_{ij}$ du détecteur DET(i,j) de ce point élémentaire est donnée par l'expression :

$$\delta Vpel_{ij} = Id_{ij} \times Tpose / Cpel$$

où la Cpel est la capacité du condensateur de stockage du point élémentaire.

La variation de la tension de sortie, $\delta Vpel_{ij}$, correspondant à la lecture du point élémentaire PEL(i,j) est donnée par la relation :

$$\delta Vs_{ij} = Apel \times As \times \delta Vpel_{ij} = Apel \times As \times Ib_{ij} \times Tpose / Cpel$$

où Apel (respectivement As) est le gain en tension de l'amplificateur de tension du point élémentaire (respectivement de l'amplificateur de sortie).

Ce type d'architecture de circuit présente l'avantage d'être compatible avec un adressage aléatoire des points élémentaires, autrement dit la réalisation de sous-images.

Une première limitation est liée au mode de lecture des détecteurs. En effet, dans le cas où le temps de pose doit être identique et synchrone pour tous les détecteurs, il faut échantillonner-bloquer la tension aux bornes du condensateur de stockage dans le point élémentaire. Cette fonction impose alors des contraintes supplémentaires dans la conception du point élémentaire qu'il sera d'autant plus difficile à satisfaire que le pas du point élémentaire est petit. En particulier, la surface du condensateur de stockage, donc sa capacité, diminue. La réduction de la charge stockable se traduit alors par une dégradation du rapport signal sur bruit.

Une autre limitation de ce type d'architecture est liée à la cadence de lecture qui impose des contraintes de dimensionnement à l'amplificateur de tension du point élémentaire et à l'interrupteur qui permet la connexion entre les sorties des points élémentaires d'une même colonne à l'amplificateur de sortie. En effet, le temps d'établissement du signal en sortie de l'amplificateur du point élémentaire doit être inférieur à la période de sortie du signal vidéo. Il faut pratiquement :

- que l'amplificateur du point élémentaire soit capable de fournir un courant élevé;
- que la résistance de l'interrupteur soit suffisamment faible pour ne pas diminuer de manière significative le gain en tension de l'amplificateur ;
- que le couplage capacitif dû au point diviseur entre la capacité entrée-sortie de l'amplificateur du point élémentaire et la capacité de stockage soit tel que la tension échantillonnée-bloquée sur l'entrée de l'amplificateur du point élémentaire ne soit pas modifiée de manière significative.

Ces contraintes sont d'autant plus difficiles à satisfaire que le nombre de détecteurs augmente et que le pas des points élémentaires diminue alors que la cadence image reste constante et que le nombre de sorties a plutôt tendance à diminuer.

Enfin, il faut absolument intégrer dans le point élémentaire un dispositif spécifique, pour remplir la fonction de remise à zéro du point élémentaire, ce qui nécessite au moins un transistor de plus.

**Circuits de lecture de type partition bus colonne**

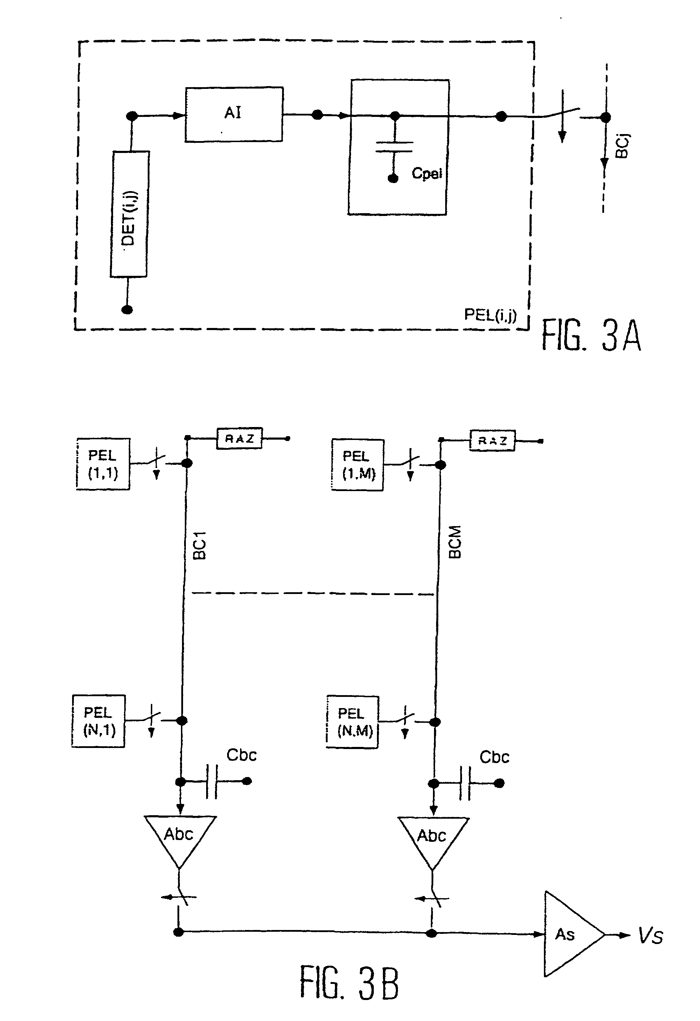

Pour des circuits de lecture de type partition bus colonne, un schéma de principe est donné sur les figures 3A et 3B.

On trouve au minimum dans chaque point élémentaire représenté sur la figure 3A :

- un interrupteur ou un dispositif d'adaptation d'impédance AI entre un détecteur DET(i,j) et un condensateur d'intégration;

- un condensateur Cpel dont la capacité, soit celle du canal d'inversion d'un condensateur MOS, soit la capacité grille-source d'un transistor MOS, permet de convertir le courant en tension par intégration ;
- un interrupteur qui permet de commuter une borne du condensateur d'intégration du point élémentaire sur une connexion commune aux points élémentaires d'une même colonne, dite bus colonne BCj.

Un amplificateur Abc de tension à forte impédance d'entrée, mais à faible capacité d'entrée, est implanté en bout de chaque bus colonne BCj, ainsi qu'un interrupteur de remise à zéro des condensateurs d'intégration.

Le multiplexage des sorties de ces amplificateurs de tension vers un ou plusieurs amplificateurs de sortie As se fait au moyen d'interrupteurs implantés à la sortie de chacun de ces amplificateurs.

Le multiplexage des sorties de ces amplificateurs de tension vers un ou plusieurs amplificateurs de sortie se fait au moyen d'interrupteurs implantés à la sortie de chacun de ces amplificateurs.

A chaque trame, le courant du détecteur est intégré dans le condensateur d'intégration pendant une durée Tpose. A la fin du temps d'intégration, une ligne est sélectionnée et les interrupteurs des points élémentaires de cette ligne sont fermés sur les bus d'interconnexion qui ont été préalablement convenablement initialisés. Le système formé par le condensateur de stockage et le bus colonne étant isolé, la tension finale du bus colonne est fonction de sa capacité et de celle de stockage. Dès que cette tension est stabilisée, la tension de sortie des amplificateurs de colonnes est multiplexée vers le (les) amplificateur(s) de sortie. Il est alors possible de réinitialiser le condensateur d'intégration d'une même ligne au moyen des interrupteurs de remise à zéro situés à l'extrémité de chaque bus colonne.

La charge $Qpel_{ij}$ intégrée dans le point élémentaire PEL(i,j) en fonction du courant, $Id_{ij}$ du détecteur de ce point élémentaire et du temps de pose Tpose est donnée par l'expression:

$$Qpel_{ij} = Id_{ij} \times Tpose$$

La variation de tension, $\delta Vbc_{ij}$, du bus colonne après commutation du condensateur du point élémentaire PEL(i,j) est obtenue en écrivant réquation de la conservation de charge (on suppose ici que la charge initiale sur le bus colonne est nulle) :

$$\delta Vbc_{ij} = Qpel_{ij} / (Cpel+Cbc) = Id_{ij} \times Tpose / (Cpel+Cbc)$$

où Cpel (respectivement Cbc) est la capacité du condensateur de stockage dans le point élémentaire (respectivement capacité du bus colonne).

La variation de tension de sortie, $\delta Vbc_{ij}$, correspondant à la lecture de l'information délivrée par le point élémentaire PEL(i,j) est donnée par la relation suivante :

$$\delta Vs_{ij} = As \times Abc \times \delta Vbc_{ij} = As \times Abc \times Id_{ij} \times Tpose / (Cpel+Cbc)$$

où Abc (respectivement As) est le gain en tension de l'amplificateur de tension d'un bus colonne (respectivement de l'amplificateur de sortie).

Les avantages et les inconvénients de cette architecture sont quasiment les mêmes que ceux de la structure à suiveurs commutés, à la différence près que les inconvénients liés à la présence de l'amplificateur disparaissent. Quant à la remise à zéro du point élémentaire, il n'est pas absolument nécessaire d'implanter dans le point élémentaire un dispositif spécifique car il est possible de réinitialiser le condensateur d'intégration via le bus colonne.

Il faut cependant que l'utilisateur s'accommode de la réduction de gain due à l'atténuation du signal contrôlée par la valeur de la capacité du bus colonne. Ce point peut être rédhibitoire en terme de rapport signal sur bruit pour des circuits de grand format, donc à Cbc élevé, et/ou pour des applications où la charge à manipuler est petite.

**Circuits de lecture de type intégration déportée**

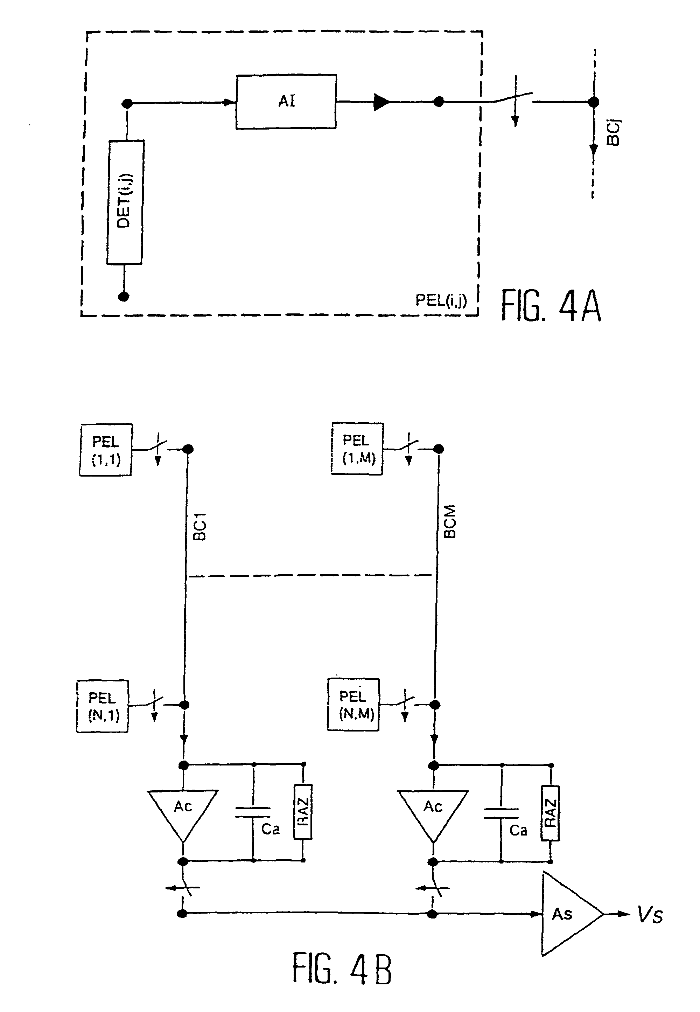

Pour des circuits de lecture de type intégration déportée, tels que décrits notamment dans les références [4] et [5] citées en fin de description, un schéma de principe est donné sur les figures 4A et 4B.

Dans chaque point élémentaire on trouve au minimum, car le dispositif d'adaptation d'impédance AI n'est pas toujours absolument nécessaire, un interrupteur qui permet de commuter le détecteur DET(i,j) sur une connexion commune aux points élémentaires d'une même colonne, dite bus colonne BCj. Puis, à l'extrémité de chaque colonne, on trouve un amplificateur de charges Ac, c'est-à-dire un amplificateur de tension contre-réactionné par un condensateur.

Le multiplexage des sorties de ces amplificateurs de charges Ac vers un ou plusieurs amplificateurs de sortie As se fait au moyen d'interrupteurs implantés à la sortie de chacun de ces amplificateurs de charges.

A chaque trame, les lignes de détecteurs sont sélectionnées les unes après les autres. Au moment voulu, les détecteurs de la ligne adressée sont commutés sur les bus colonnes en fermant les interrupteurs implantés dans les points élémentaires de la ligne considérée, pendant une durée égale au temps de pose (Tpose).

Le courant $Id_{ij}$ délivré par le détecteur DET(i,j) est intégré pendant Tpose par l'amplificateur de charges connecté au bus colonne BCj. A la fin du temps de pose, la tension de sortie de l'amplificateur de charge est lue par la chaîne d'acquisition. Une autre ligne peut alors être sélectionnée après que les amplificateurs de charges ont été convenablement réinitiatisés.

La variation de tension de sortie $\delta Vc_{ij}$ de l'amplificateur de charge Acj sur lequel a été commuté le détecteur DET(i,j) est donnée par la formule :

$$\delta Vc_{ij} = Id_{ij} \times Tpose / Ca$$

où Ca est la capacité du condensateur de contre-réaction de l'amplificateur de charges.

La variation de tension de sortie $\delta Vs_{ij}$ correspondant à la lecture de l'information délivrée par le point élémentaire PEL(i,j) est donnée par la relation suivante :

$$\delta Vs_{ij} = As \times \delta Vc_{ij} = As \times Id_{ij} \times Tpose / Ca$$

où As est le gain en tension de l'amplificateur de tension de sortie.

Cette architecture ne nécessite qu'un interrupteur par point élémentaire, d'où son domaine d'application dans les mosaïques à pas réduit. En particulier un interrupteur de remise à zéro n'est pas indispensable dans le point élémentaire.

Par contre, il est clair que ce type d'architecture n'est pas compatible avec un temps de pose identique et synchrone pour tous les points élémentaires.

Par ailleurs, cette architecture impose une contrainte sur le temps de pose qui doit être inférieur ou égal à la période du signal de sortie vidéo divisé par le nombre de lignes à lire. Cette contrainte limite le rapport signal sur bruit de ce type de circuit de lecture pour des applications à grand nombre de points et à nombre de sorties réduites.

Le problème est de concevoir un point élémentaire qui permette de lire le signal délivré par une mosaïque de détecteurs quantiques ou bien de détecteurs thermiques sachant qu'il faut :

- un temps de pose identique et synchrone pour tous les détecteurs de la mosaïque (cette caractéristique de la prise de vues sera désignée par la suite par prise d'images flash) ;
- maximiser la charge stockable dans le point élémentaire pour avoir un rapport signal sur bruit optimal.

Pour pallier les inconvénients des circuits de lecture de l'art antérieur passés en revue ci-dessus, la présente invention a pour objet une architecture où la grandeur électrique traitée par le circuit de lecture n'est ni le courant, ni la tension, mais la charge, par préintégration dans le point élémentaire du courant délivré par le détecteur, comme dans une solution de type DTC, puis par lecture de cette charge par un amplificateur de charges, comme dans les circuits à intégration déportée.

La référence [7] citée en fin de description décrit une matrice de capteurs sensibles aux rayons X ou à la lumière, disposés en rangées et en colonnes, qui génèrent des charges en fonction de la quantité de rayonnement incident. Chaque capteur comprend un commutateur. Chaque rangée de capteurs comporte une ligne de commutation grâce à laquelle les commutateurs peuvent être activés de telle sorte que les charges des rangées de capteurs activés concernés sont sorties simultanément par les lignes de lecture. Un amplificateur, disposé dans chaque ligne de lecture, amplifie, pendant les opérations de lecture, les charges provenant des capteurs connectés à la ligne de lecture concernée. Un multiplexeur convertit les charges, qui arrivent simultanément et en parallèle, en un signal série.

La référence [8] décrit un capteur image à base de CMOS. Un capteur pixel actif est défini comme une technologie à réseau de détecteurs avec un ou plusieurs transistors actifs dans chaque cellule unité pixel. Une telle cellule comprend une photo-grille, une grille de transfert polarisée en continu et une diffusion de sortie, ainsi qu'un transistor de remise à zéro, un transistor d'entrée suiveur de source et un transistor de sélection de rangée. Essentiellement un circuit CCD à canal de surface est fabriquée dans chaque pixel. A l'extrémité de chaque colonne de pixel, il y a un transistor de charge et deux branches de sortie pour emmagasiner les niveaux de signaux et de remise à zéro.

La référence [9] décrit un dispositif d'imagerie à l'état solide qui comprend une pluralité d'éléments de conversion photoélectriques, par exemple des photodiodes, disposés sur un substrat semi-conducteur de manière à former une matrice et des moyens de lecture, réalisés avec des moyens actifs tels que des transistors MOS connectés à une photodiode, pour lire les charges de signal qui sont emmagasinées dans les photodiodes en fonction de la lumière incidente, dans un ordre prédéterminé. Une partie des éléments actifs est utilisée comme un amplificateur de pixel pour amplifier la charge de signal de la photodiode de telle sorte que celle-ci soit convertie en courant ou en tension.

La référence [10] décrit une nouvelle technique de lecture de grandes matrices à deux dimensions de photodiodes p-i-n de silicium amorphe, adressées par des transistors à film mince, utilisant un amplificateur IC sensible à la charge.

La référence [5] décrit l'utilisation de réseaux à plan focal dans des systèmes de détection infrarouge.

La référence [11] décrit un système d'imagerie passive infrarouge composé de détecteurs photovoltaïques, de capacités d'intégration, et de transistors MOS réalisés sur un semi-conducteur à largeur de bande interdite étroite.

Exposé de l'invention

La présente invention concerne un dispositif de lecture d'une matrice de détecteurs photoniques, qui délivre un courant dont l'intensité varie en fonction du flux incident, le temps de pose étant identique et synchrone pour tous les détecteurs, qui comprend :

- un ensemble de points élémentaires permettant de lire les signaux délivrés par chaque détecteur,
- plusieurs amplificateurs de charges connectés chacun à l'extrémité d'un bus colonne,
- au moins un amplificateur de sortie, le multiplexage des sorties des amplificateurs de charge vers les entrées de cet au moins amplificateur de sortie se faisant au moyen d'interrupteurs, dont

    chaque point élémentaire comprend :

- • un détecteur,
- • un dispositif d'intégration et de stockage,
- • un dispositif d'adaptation d'impédance disposé entre ce détecteur et de dispositif d'adaptation et de stockage,
- • un dispositif d'adressage apte à commuter la sortie du dispositif d'intégration et de stockage sur un bus colonne commun à tous les points élémentaires d'une même colonne. L'amplificateur de charges est extérieur au point élémentaire dans le cas d'une matrice de détecteurs. Dans celui d'une barrette de détecteurs, l'amplificateur de charges est situé soit à l'extérieur, soit à l'intérieur du point élémentaire.

Avantageusement les détecteurs photoniques sont des détecteurs quantiques, ou des détecteurs thermiques. Ils sont réalisés sur un autre substrat que ledit dispositif de lecture, ou directement sur le circuit du dispositif de lecture.

Chaque point élémentaire comprend :

- un dispositif d'adaptation d'impédance ;
- un dispositif d'intégration, de stockage et d'évacuation de charge ;
- un dispositif d'adressage.

Le dispositif d'adaptation d'impédance est situé entre le détecteur considéré et le dispositif de stockage. Le dispositif de stockage est réalisé au moyen d'au moins un transistor MOS dont la source et/ou le drain sont connectés au détecteur via un interrupteur et dont la grille est pilotée par une horloge. Le dispositif d'adressage permet de commuter la source et/ou le drain du transistor MOS de stockage sur une connexion commune aux points élémentaires d'une même colonne, dite bus colonne.

Avantageusement le dispositif d'adaptation d'impédance est un transistor MOS. Le dispositif d'adressage est un transistor MOS utilisé en interrupteur, le niveau analogique appliqué sur sa grille pour le rendre passant est tel que la valeur absolue de la différence de potentiel grille-source est légèrement supérieure à la valeur absolue de la tension de seuil du transistor MOS.

Avantageusement le temps d'établissement du signal de sortie de l'amplificateur de charges est inférieur au temps de descente de l'horloge qui pilote la grille du transistor. Dans le cas d'une barrette de détecteurs soit il y a une connexion commune et un seul amplificateur de charges, soit il n'y a pas de connexion commune et autant d'amplificateurs de charges que de lignes dans la barrette, le multiplexage étant limité au multiplexage des amplificateurs de charges.

Avantageusement l'amplificateur de charges comprend :

- un préamplificateur d'entrée ;

- un condensateur de contre-réaction dont la capacité est égale à la charge maximum à lire divisée par l'excursion de tension de sortie de l'amplificateur;
- un amplificateur différentiel dont le produit gain x bande est adapté au temps de montée de l'impulsion de courant qui est injectée dans le bus.

Avantageusement chaque point élémentaire est constitué :

- d'un dispositif d'adaptation d'impédance, muni d'une première horloge, apte à polariser le détecteur correspondant et à lire le courant fourni par ce détecteur ;
- au moins d'un transistor MOS, muni d'une seconde horloge apte d'une part à intégrer le courant fourni par le détecteur et, d'autre part, associé à un dispositif d'adressage, à stocker la charge obtenue ;
- le dispositif d'adressage, muni d'une troisième horloge, apte à commuter la source et/ou le drain du transistor MOS sur une connexion commune des points élémentaires d'une même colonne appelée bus colonne.

Avantageusement, dans chaque point élémentaire, le dispositif d'adaptation d'impédance est relié par son entrée au détecteur, par sa sortie à la source et/ou au drain de ce transistor MOS et par sa commande à une première horloge qui commute entre la tension de blocage et une tension de polarisation Vpol. La grille du transistor MOS est reliée à une seconde horloge qui commute entre une tension qui permet de stocker les charges et une tension qui permet l'évacuation de la charge stockée sur une connexion commune. Avantageusement la tension qui permet de stocker les charges est la masse pour un transistor NMOS et est égale à la tension de polarisation pour un transistor PMOS. Le dispositif d'adressage est relié, par son entrée à la connexion vacante (source ou drain) du transistor MOS, par sa sortie au bus colonne et par sa commande à une troisième horloge qui commute entre la masse et la tension de polarisation Vécran. L'amplificateur de charges est connecté en entrée aux dispositifs d'adressage, via le bus colonne, et en sortie au suiveur vidéo.

La présente invention concerne également un procédé de lecture d'une matrice de détecteurs photoniques comprenant un dispositif de lecture selon la revendication 1, qui délivre un courant dont l'intensité varie en fonction du flux incident, le procédé comprenant les étapes suivantes :

- polarisation du détecteur et conversion du courant du détecteur en charge par intégration d'une durée égale au temps de pose ;
- conversion de la charge intégrée en une impulsion de courant dont l'amplitude est ajustable en fonction d'un stimulus et dont la durée varie en fonction de la charge stockée ;
- conversion de cette impulsion de courant en tension au moyen d'un amplificateur contre-réactionné par une capacité.

Avantageusement il comporte les étapes suivantes :

- La première horloge Hp étant au niveau de la tension de polarisation Vpol, la seconde HCi (i est le numéro des lignes) étant au niveau permettant le stockage des charges et la troisième à la tension de blocage : une fois par image, intégration du courant fourni par le détecteur dans le transistor MOS (stockage) pendant un temps prédéfini en fonction des conditions d'éclairement de la scène, des caractéristiques du détecteur, de la valeur de la capacité de stockage.
- La première horloge Hp revenant à sa tension de blocage ; la seconde horloge HCi variant de façon linéaire depuis le niveau permettant le stockage des charges jusqu'au niveau bloquant le transistor (le taux de variation étant déterminée par rapport aux caractéristiques de l'amplificateur) ; et, la troisième horloge HAi commutant au niveau Vécran : étape d'évacuation des charges réalisée pour chaque ligne de la matrice ; la seconde horloge HCi étant à la tension de blocage ; la troisième horloge HAi commutant à la tension de blocage et on recommence pour la ligne suivante.
- On a balayé toutes les lignes, on recommence les étapes précédentes pour une autre image.

L'invention permet de simplifier l'électronique d'un circuit de lecture en supprimant les dispositifs de remise à zéro présents dans le point élémentaire même des dispositifs de l'art antérieur. Cette fonction est néanmoins conservée mais elle est effectuée par un amplificateur de charges extérieur au point élémentaire sauf pour un des cas particuliers de la barrette de détecteurs où l'amplificateur est situé à l'intérieur du point élémentaire.

Dans l'invention, on s'intéresse à une ligne:

- multiplexage de cette ligne sur les bus colonnes ;
- multiplexage des amplificateurs et ceci autant de fois qu'il y a de lignes.

La charge ne peut être stockée sur le transistor MOS de stockage que pour des positions particulières des deux premières horloges l'une par rapport à l'autre, à un niveau prédéterminé.

L'horloge qui commande la grille du transistor de stockage est pilotée entre la masse et la tension maximum appliquée au circuit de lecture. Dans le cas d'un transistor NMOS le front de descente doit être compatible avec les caractéristiques de la bande passante de l'amplificateur de charge, alors que dans le cas d'un transistor PMOS le front montant doit être compatible avec les caractéristiques de la bande passante de l'amplificateur de charges.

Les avantages de l'invention sont les suivants :

- d'une part la fréquence de fonctionnement de l'imageur est limitée seulement par le dimensionnement du suiveur vidéo, alors que dans les dispositifs de l'art antérieur le suiveur du point élémentaire limite en plus la fréquence de fonctionnement ;
- d'autre part, dans une perspective d'augmentation des formats des imageurs, il est nécessaire d'augmenter le nombre de détecteurs tout en diminuant la taille du point élémentaire et leur espacement ; et
- enfin, l'invention permet de réaliser des circuits de lecture avec une technologie CMOS qui a la particularité de permettre à la fois une grande densité d'intégration et une lecture aléatoire des détecteurs contrairement aux dispositifs de l'art antérieur, réalisés avec une technologie CCD.

Brève description des dessins

- Les figures 1A et 1B illustrent une architecture de circuit de lecture de l'art antérieur de type à transfert de charges ;
- les figures 2A et 2B illustrent une architecture de circuit de lecture de l'art antérieur de type suiveur commuté ;
- les figures 3A et 3B illustrent une architecture de circuit de lecture de l'art antérieur de type partition bus colonne ;
- les figures 4A et 4B illustrent une architecture de circuit de lecture de l'art antérieur de type intégration déportée ;
- les figures 5A et 5B illustrent une architecture de circuit de lecture selon l'invention ;
- la figure 6 illustre le schéma électrique de principe du dispositif de l'invention ;
- la figure 7 illustre les variations au cours d'un cycle complet de fonctionnement des profils de potentiel dans un point élémentaire selon l'invention ;
- la figure 8 illustre un chronogramme de lecture de deux points élémentaires selon l'invention ;
- la figure 9 illustre le séquencement des horloges d'un circuit de lecture selon l'invention ;
- les figures 10A et 10B et 11A et 11B illustrent l'implantation et le schéma électrique d'une mosaïque de deux lignes par deux colonnes de points élémentaires, respectivement pour un circuit de lecture de l'art antérieur de type suiveur commuté et pour un circuit de lecture selon l'invention ;
- la figure 12 illustre le schéma de principe de calibration électrique selon l'invention ;
- la figure 13 illustre le schéma de principe d'un circuit multi-application ;
- la figure 14 illustre le schéma de principe d'un circuit de lecture du type TDI selon l'invention.

Exposé détaillé de modes de réalisations

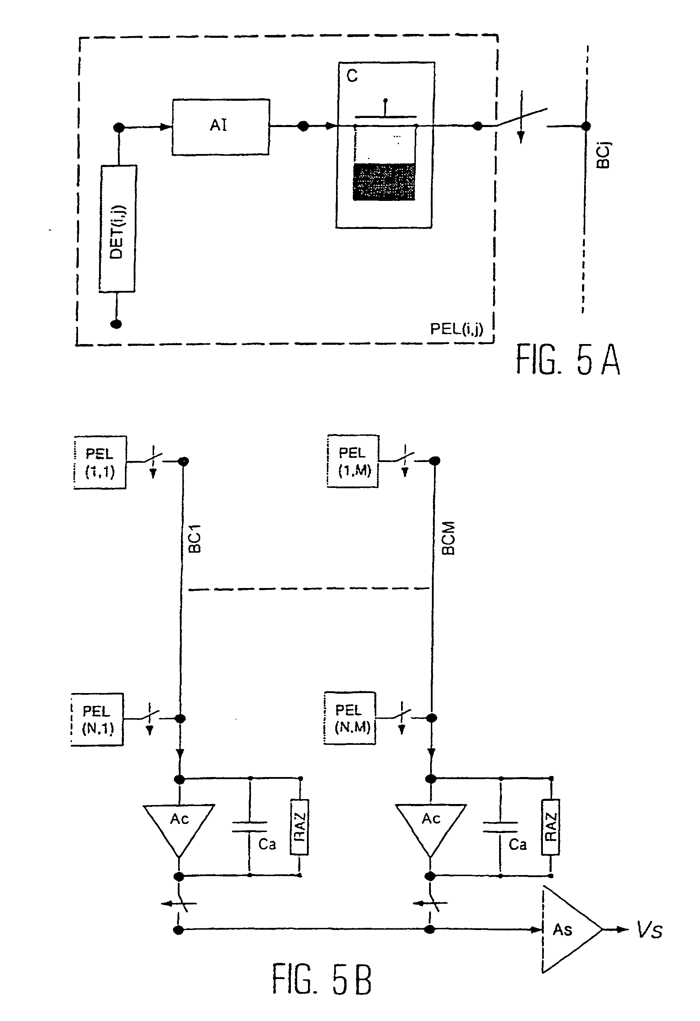

Le schéma de principe du point élémentaire proposé est représenté sur les figures 5A et 5B.

On trouve dans celui-ci :

- un dispositif d'adaptation d'impédance AI entre un détecteur DET(i,j) et un dispositif d'intégration, de stockage et d'évacuation d'une charge ;
- le dispositif d'intégration et de stockage Cpel réalisé par exemple au moyen d'un transistor MOS dont la source et/ou le drain sont connectés au détecteur via le dispositif d'adaptation d'impédance et dont la commande est pilotée par une horloge ;
- un dispositif d'adressage, symbolisé, dans un souci de simplification, par un interrupteur, qui permet de commuter la source et/ou le drain du transistor MOS sur une connexion commune aux points élémentaires d'une même colonne, dite bus colonne BCj pour évacuer les charges.

Un amplificateur de charges Acj est connecté à l'extrémité de chaque bus colonne BCj. Le multiplexage des sorties amplificateur de charges vers un ou plusieurs amplificateurs de sortie As se fait au moyen d'interrupteurs.

A chaque trame, les interrupteurs situés entre les détecteurs et le transistor MOS de stockage sont fermés de manière synchrone, les interrupteurs situés entre les transistors MOS et les bus colonnes BCj étant ouverts.

Le courant délivré par chaque détecteur est alors intégré dans le canal d'inversion du transistor MOS pendant une durée Tpose.

A la fin du temps de pose, les interrupteurs situés entre les détecteurs et les transistors MOS sont ouverts de manière synchrone. On a donc le même temps de pose pour chacun des détecteurs.

Les lignes de détecteurs sont alors sélectionnées les unes après les autres. A chaque temps ligne, les interrupteurs d'une même ligne situés entre les transistors MOS et les bus colonnes sont fermés. La grille des transistors MOS d'une même ligne est alors pulsée de façon à provoquer l'injection des charges stockées dans son canal sur le bus colonne et, par voie de conséquence, la remise à zéro de charge stockée dans le canal d'inversion du transistor MOS.

Le bus colonne étant supposé maintenu à un potentiel constant par l'amplificateur de charges dont l'impédance d'entrée est par ailleurs supposée infinie, l'impulsion de courant ainsi provoquée par l'injection de charges est convertie en tension par l'amplificateur de charges. Sa sortie peut alors être multiplexée vers la sortie vidéo pour être traitée.

Il est alors possible de réinitialiser l'amplificateur de charges, d'ouvrir le dispositif d'adressage colonne et enfin de créer un nouveau puits de potentiel, vide de toute charge, sous la grille du transistor MOS de stockage avant de procéder à la lecture de la ligne suivante.

L'expression de la variation de tension $\delta Vc_{ij}$ en sortie de l'amplificateur de charges Acj connecté à la colonne j en fonction du courant $Id_{ij}$ en délivré par le détecteur du point élémentaire PEL(i,j) est donnée par l'expression :

$$\delta Vc_{ij} = Id_{ij} \ x \ Tpose \ / \ Ca$$

où Ca est la capacité du condensateur de contre-réaction de l'amplificateur de charges.

La capacité du bus colonne n'intervient pas dans la fonction de transfert de cette solution car l'amplificateur de charges est supposé être à entrée différentielle et à courant d'entrée nul. Le bus colonne étant maintenu à un potentiel constant par cet amplificateur, il ne dérive aucun courant de déplacement. Autrement dit, il y a conservation de la charge dans le circuit.

La variation de la tension de sortie $\delta Vs_{ij}$ correspondant à la lecture de l'information délivrée par le point élémentaire PEL(i,j) est donc donnée par la relation suivante :

$$\delta Vs_{ij} = As \ x \ \delta Vc_{ij} = As \ x \ Id_{ij} \ x \ Tpose \ / \ Ca$$

où As est le gain de tension de l'amplificateur de tension de sortie.

Ce type d'architecture de circuit de lecture de mosaïque de détecteurs quantiques et de détecteurs thermiques à prise de vues flash sera désigné, dans la suite de la description, par l'acronyme anglais de "SCA" pour "Snapshot Charge Amplifier".

Exemple de réalisation

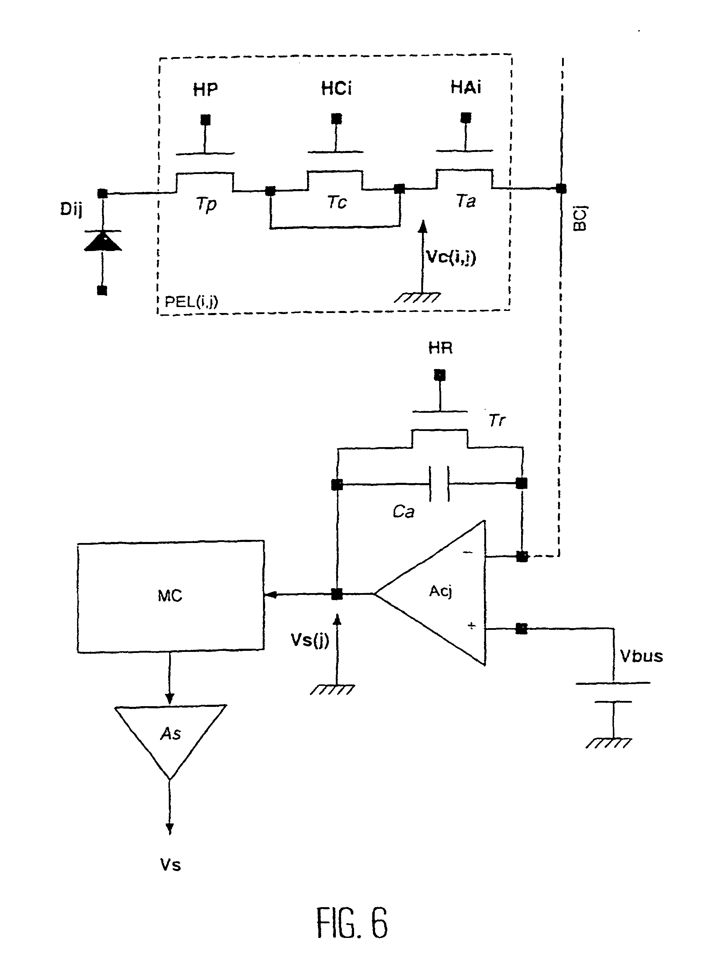

Le schéma de principe des fonctions à implanter dans un circuit de lecture flash de mosaïque de détecteurs quantiques ou de détecteurs thermiques est donné sur la figure 6.

Ce circuit est supposé lire une matrice N lignes par M colonnes de détecteurs. Le point élémentaire PEL(i,j) de la ligne i et de la colonne j y est représenté. Sa sortie attaque le bus colonne BCj qui est connecté à un amplificateur de charges Acj. Les sorties des M amplificateurs de charges sont multiptexées vers un amplificateur de tension de sortie au moyen d'un multiplexeur MC de M vers 1.

Le détecteur est supposé être un détecteur photovoltaïque de type N sur substrat P. Il est schématisé par la diode Dij.

Pour l'adaptation d'impédance entre le détecteur et le point élémentaire, un transistor NMOS Tp est ici monté en grille commune, c'est-à-dire qu'il présente une faible impédance d'entrée et une très forte impédance de sortie. Sa source est connectée au détecteur et son drain à la source d'un transistor NMOS d'intégration Tc.

Ce principe de couplage des détecteurs photovoltaïques à leurs circuits de lecture est très classique et est souvent désigné par injection directe dans la littérature. Il en existe de nombreuses variantes destinées principalement à diminuer l'impédance d'entrée et/ou à augmenter l'impédance de sortie.

Une horloge, désignée par HP, est appliquée à la grille de tous les transistors Tp de la mosaïque.

La fonction d'intégration est ici réalisé au moyen d'un transistor NMOS Tc dont la source et le drain peuvent être court-circuités comme c'est le cas sur la figure.

Les diodes de source et de drain de Tc sont reliées d'une part au drain de Tp et d'autre part, à la diode d'entrée du transistor NMOS d'adressage Ta.

Une horloge HCi est appliquée à la grille de Tc. L'indice i précise que tous les transistors Tc d'une même ligne sont attaqués par cette horloge et que chaque ligne du circuit de lecture est attaquée par une horloge différente.

Le transistor NMOS d'adressage Ta est monté en interrupteur entre les source et drain de Tc et la connexion bus colonne BCj.

Une horloge HAi est connectée à sa grille. L'indice i précise que cette horloge attaque tous les transistors Ta de la ligne et que chaque ligne du circuit de lecture est attaquée par une horloge différente.

En ce qui concerne l'amplificateur de charges, le bus colonne est connecté à l'entrée inverseuse d'un amplificateur différentiel Ac contre-réactionné par un condensateur Ca.

L'entrée non-inverseuse de l'amplificateur de charges est connectée à une alimentation Vbus.

Le transistor Tr est monté en parallèle sur Ca. Il est utilisé comme interrupteur pour réinitialiser le condensateur Ca entre la lecture de deux lignes consécutives. Sa grille est pilotée par une horloge HR.

**Fonctionnement du point élémentaire**

Avant de décrire le fonctionnement électrique d'un point élémentaire, il est indispensable d'exposer les principes qui gouvernent le dimensionnement de ce type de circuit et le réglage des différents stimulis.

Les horloges utilisées pour piloter ce circuit sont supposées commutées entre deux niveaux analogiques qui ne sont pas toujours égaux aux tensions d'alimentations (Vdd, Vss) des circuits comme c'est souvent l'usage. Par convention, dans la suite de la description la tension de sortie des horloges :

- à l'état haut est notée H(1);
- à l'état bas est notée H(0).

Le transistor de polarisation a deux fonctions :

- polariser le détecteur ;
- contrôler le temps de pose.

La première fonction est obtenue en appliquant à la grille de ce transistor NMOS une tension telle qu'il soit polarisé en régime de saturation, c'est-à-dire dans une zone où il présente une résistance dynamique drain-source élevée. Dans le cas de l'invention, il suffit d'appliquer à la grille de Tp une tension sensiblement égale à la tension de seuil Vtn de ce transistor MOS.

La deuxième fonction est obtenue en appliquant à la grille de Tp une tension telle que Tp soit bloqué. Dans le cas de l'invention, il suffit d'appliquer à la grille de Tp une tension Vtb qui garantit que Tp ne laisse passer aucun courant, même en régime de faible inversion. Pratiquement, il suffit d'appliquer la tension minimum autorisée par la filière, désignée ici par Vss, pour avoir une marge de bruit suffisante.

Le transistor de polarisation remplit donc ses fonctions si l'horloge Hp commute entre les niveaux suivants :

- $HP(1) \approx Vtn$ ;
- $HP(0) = Vtb \approx Vss$.

Le transistor MOS d'intégration et de stockage Tc doit être piloté par une horloge Hc de façon à ce qu'il remplisse les trois fonctions suivantes :

- maximiser la charge stockable ;
- réinitialiser sa capacité entre deux images ;
- contrôler le courant qui sera injecté dans l'amplificateur de charges à chaque lecture.

Dans la plupart des applications, il est souhaitable de maximiser le rapport signal sur bruit dès le premier étage du circuit de lecture, ce qui revient en général à maximiser la charge stockable dans le canal d'inversion de Tc.

Pour ce faire, il suffit d'appliquer à la grille de Tc la tension maximum autorisée par la filière que l'on désignera ici par Vdd. La charge stockable maximum Qsm dans le point élémentaire peut alors être approximée par la formule suivante (en négligeant la capacité des diodes de source et drain de Tp, Tc et Ta, et autres capacités parasites connectées à ce même noeud électrique) :

$$Qsm = Cox \times S \times (Vdd-Vtn)$$

où :

- Cox est la capacité par unité de surface de la grille de Tc ;
- S est la surface active de la grille de Tc ;
- Vtn est la tension de seuil du transistor NMOS Vtn.

La réinitialisation du condensateur d'intégration sera parfaite si la tension appliquée à la grille de Tc fait passer le canal en régime d'accumulation. Autrement dit, il ne sera plus possible d'y stocker des électrons. Pour ce faire, il faut que cette tension soit inférieure à la tension de seuil de Tc. Il est souvent commode, tout comme pour Tp, d'utiliser l'alimentation Vss.

En résumé, l'horloge HCi doit, pour satisfaire les deux premières contraintes, être commutée entre les niveaux :

- HCi(1) = Vdd ;
- HCi(0) = Vss.

La troisième fonction est satisfaite en maîtrisant le temps de descente de cette horloge. Ce point sera abordé dans la suite dans un paragraphe qui traite du transistor NMOS d'adressage.

L'amplificateur de charges doit satisfaire les contraintes suivantes :

- avoir une excursion de sortie la plus grande possible afin de maximiser son facteur de conversion charge-tension ;
- maintenir le bus colonne à un potentiel constant pendant la lecture des charges stockées dans un point élémentaire ;
- consommer le moins possible afin de minimiser la consommation dans les circuits de lecture de composants de grand format.

Dans le cas de l'invention, les charges injectées dans la capacité de contre-réaction de l'amplificateur de charges sont des électrons. La tension de sortie de cet amplificateur de charges augmente donc lorsque l'on y injecte des charges. La première contrainte est donc satisfaite en utilisant :

- un préamplificateur d'entrée qui s'accommode d'une faible tension d'entrée ;
- un condensateur de contre-réaction dont la capacité est égale à la charge maximum à lire divisée par l'excursion de tension de sortie de l'amplificateur.

On peut montrer que le deuxième point est satisfait en utilisant un amplificateur différentiel dont le produit gain x bande est adapté au temps de montée de l'impulsion de courant qui est injectée dans le bus.

Si tel n'était pas le cas, le courant intégré dans la capacité de contre-réaction ne serait pas égal au courant débité par le point élémentaire, soit parce qu'une partie du courant délivré par le point élémentaire serait dérivée de l'entrée de l'amplificateur sous forme d'un courant de déplacement dû au transitoire de tension sur la capacité du bus colonne, soit parce que l'amplificateur différentiel serait parti en saturation, ce qui aurait pour effet de modifier la capacité ramenée sur le bus. Dans un cas comme dans l'autre la tension de sortie de l'amplificateur de charge à l'état final ne serait pas directement proportionnelle à la charge stockée dans le point élémentaire.

Il est donc clair que ce type de circuit est d'autant plus performant que le point élémentaire est capable de conditionner le temps de montée de l'impulsion de courant qu'il délivre, de façon à ce que le concepteur puisse optimiser les caractéristiques de produit gain x bande et de consommation de son amplificateur, ces caractéristiques étant d'autant plus critiques que les applications envisagées traitent un nombre toujours croissant de points élémentaires, et ce à une fréquence toujours plus élevée.

En conclusion, la tension de l'alimentation Vbus appliquée à l'entrée non-inverseuse de l'amplificateur doit être la plus petite possible. On peut considérer que pratiquement, dans le cas d'un amplificateur différentiel classique, Vbus doit être supérieure de quelques centaines de millivolts à la tension de seuil d'un transistor NMOS.

Le transistor d'adressage doit remplir trois fonctions :

- garantir l'isolement électrique entre le canal de Tc et le bus colonne afin qu'aucune charge ne puisse être échangée entre le bus colonne et le condensateur d'intégration du point élémentaire considéré en dehors de la lecture de ce point élémentaire ;
- ne pas retenir une partie de la charge injectée sur le bus colonne ;
- minimiser le temps de montée de l'impulsion de courant induite par ce transfert de charges.

La première contrainte est satisfaite en appliquant sur la grille de Ta une tension inférieure à sa tension de seuil, ce qui a pour effet de bloquer ce transistor. Pour ce faire, il est commode, tout comme pour le transistor de polarisation, d'utiliser l'alimentation Vss comme niveau bas.

La deuxième contrainte est obtenue en appliquant sur la grille de Ta une tension telle que le potentiel de canal à vide de Tc soit légèrement inférieur à Vbus. La marche de potentiel ainsi créée entre le canal de Tc et le bus colonne assure le transfert de tous les électrons stockés dans le canal de Ta. Une estimation grossière de la tension à appliquer consiste à écrire que Ta doit être passant, autrement dit que sa tension grille doit être égale à sa tension source, égale à Vbus, plus sa tension de seuil, en tenant compte de l'effet substrat.

C'est la troisième contrainte qui met en évidence le fait que Ta ne doit pas être considéré comme interrupteur classique, autrement dit que le niveau haut de HAi ne doit pas être Vdd. En effet, si tel était le cas, c'est une impulsion de charges de très courte durée qui serait envoyée sur le bus lorsque Ta passerait de l'état de circuit ouvert à l'état de circuit fermé. L'impulsion de courant induite sur le bus serait alors de forte amplitude et de très faible durée, ce qui imposerait des contraintes inutiles sur certaines des caractéristiques électriques de l'amplificateur de charges. Pour éviter ce phénomène, il suffit que le potentiel de canal sous Ta joue le rôle d'une barrière de potentiel vis-à-vis des charges stockées sous Tc. Pour ce faire, il faut et il suffit que la tension appliquée à la grille de Ta à l'état haut satisfasse exactement la contrainte précédente.

Pratiquement, les niveaux des horloges HAi sont :

- HAi(0) = Vss ;
- $V_{TN} \leq HAi(1) \leq V$ bus, avec $V_{TN}$ tension de seuil des transistors de type N.

Quant à la forme de l'impulsion de courant, il est possible de l'optimiser en ajustant le taux de variation du front de descente de l'horloge HCi. En effet, la rampe de tension ainsi appliquée à la grille va avoir pour effet, dans une première approximation, de provoquer une injection de charge dans le bus colonne, par dessus la barrière de potentiel générée par Ta, à un taux constant. On obtient ainsi une impulsion de courant dont l'amplitude est proportionnelle à la capacité d'intégration et au taux de variation du front de descente de HCi. La durée de cette impulsion de courant est, quant à elle, égale à la charge stockée divisée par son amplitude.

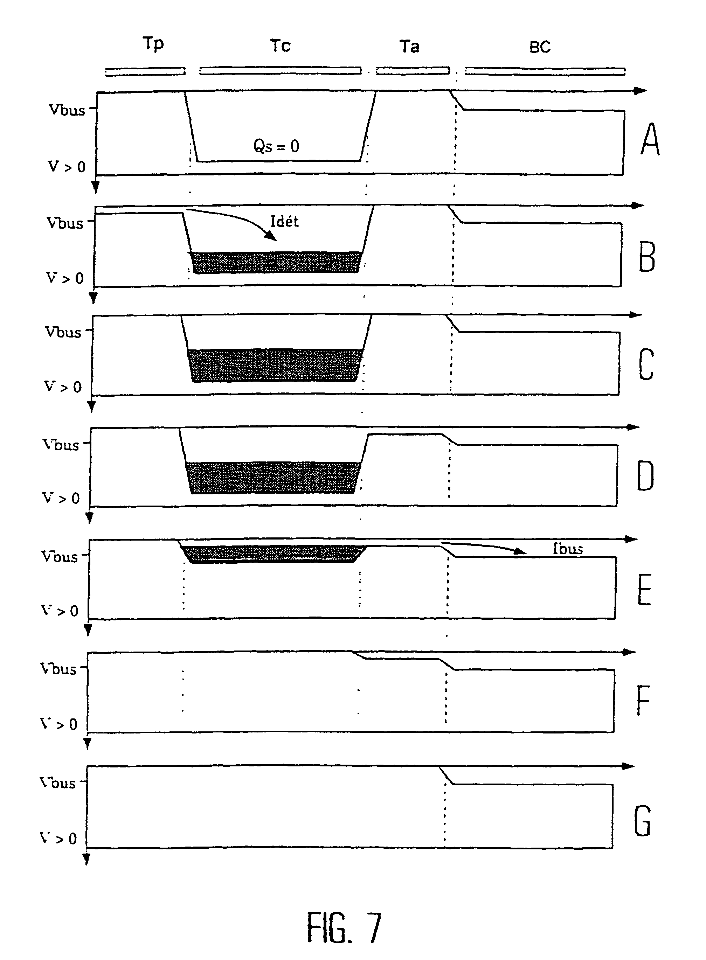

Les variations au cours du cycle complet de fonctionnement des profils de potentiels dans les différents transistors MOS du point élémentaire sont schématisées sur la figure 7. Le cycle de fonctionnement y a été découpé en sept phases :

**Phase A :** cette phase précède le temps de pose. Tp est bloqué. Le puits de potentiel sous Tc existe, mais il est vide. Ta est bloqué.

**Phase B** : le point élémentaire est en cours d'intégration. Tp est passant. Le courant débité par le détecteur est intégré dans le puits de potentiel sous Tc.

**Phase C** : c'est la fin du temps de pose. Tp est bloqué, ce qui a pour effet d'échantillonner-bloquer le potentiel sous Tc.

**Phase D** : c'est le début de la lecture du point élémentaire. Seule la tension appliquée à la grille de Ta est modifiée de façon à le rendre passant et à créer une barrière de potentielle entre Tc et le bus colonne.

**Phase E :** les charges stockées sous Tc ont été injectées par dessus la barrière de potentiel créés sous Ta dans le puits de potentiel du bus colonne.

**Phase F :** toutes les charges stockées sous Tc ont été injectées dans le bus colonne. Le puits de potentiel sous Tc est vide.

**Phase G :** c'est la fin de la lecture du point élémentaire. Ta est bloqué de façon à procéder à la lecture d'un autre point élémentaire ou bien à prendre une autre image.

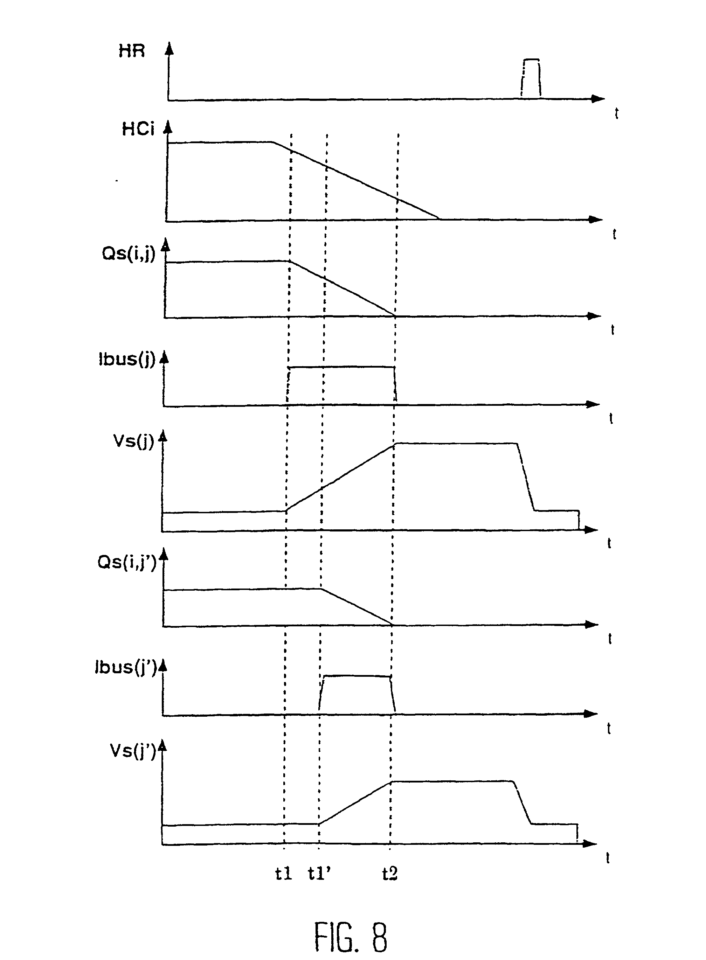

Les courbes de la figure 8 permettent de mieux comprendre comment certaines grandeurs électriques varient en fonction de la charge stockée dans le point élémentaire. Pour ce faire, on désigne par Qs(i,j) et Qs(i,j') la charge stockée dans deux points élémentaires de la même ligne i, mais de deux colonnes différentes, notées ici j et j', à la fin d'un temps de pose. La tension appliquée à la grille des transistors MOS de stockage Tc de ces deux points élémentaires est désignée par HCi. On suppose que le taux de variation de son front de descente est constant. Les courants injectés dans les bus des colonnes j et j' sont notés respectivement lbj et lbj'. Les tensions de sortie des amplificateurs de charges connectés aux bus colonnes j et j' sont notées respectivement Vsj et Vsj'.

Ces courbes mettent en évidence que le courant injecté dans le bus colonne j (respectivement j') devient non nul à partir d'un instant t1 (respectivement t1'). Ces courbes montrent clairement que cet instant varie en fonction de la charge stockée car moins cette charge est importante, plus il faut que le potentiel de canal sous Tc diminue, sous l'effet de la diminution de la tension HCi, pour que les charges stockées sous Tc puissent franchir la barrière de potentiel sous Ta.

C'est donc à partir des instant t1 et t1' que les tensions de sorties Vsj et Vsj' commencent à augmenter, et ce avec un taux de variation identique car l'intensité des courants lbj et lbj' est identique.

La lecture s'achève en fait, en première approximation, au même instant t2 pour les deux points élémentaires lorsque les dernières charges stockées dans les deux points élémentaires sont injectées dans leurs bus respectifs. Les courants Ibj et ibj' devenant nuls à partir de l'instant t2, les tensions de sorties Vsj et Vsj' n'évoluent plus. Il est alors possible de les multipiexer vers un amplificateur de sortie.

En résumé, on peut considérer que l'invention conditionne le courant délivré par les détecteurs quantiques et les détecteurs bolométriques résistifs de la manière suivante :

- conversion du courant du détecteur en charge par intégration d'une durée égale au temps de pose ;
- conversion de la charge intégrée en une impulsion de courant dont l'amplitude est ajustable en fonction d'un stimulus (ce stimulus peut être généré sur le circuit de lecture) et dont la durée varie en fonction de la charge stockée ;
- conversion de cette impulsion de courant en tension au moyen d'un amplificateur contre-réactionné par une capacité.

**Fonctionnement du circuit de lecture**

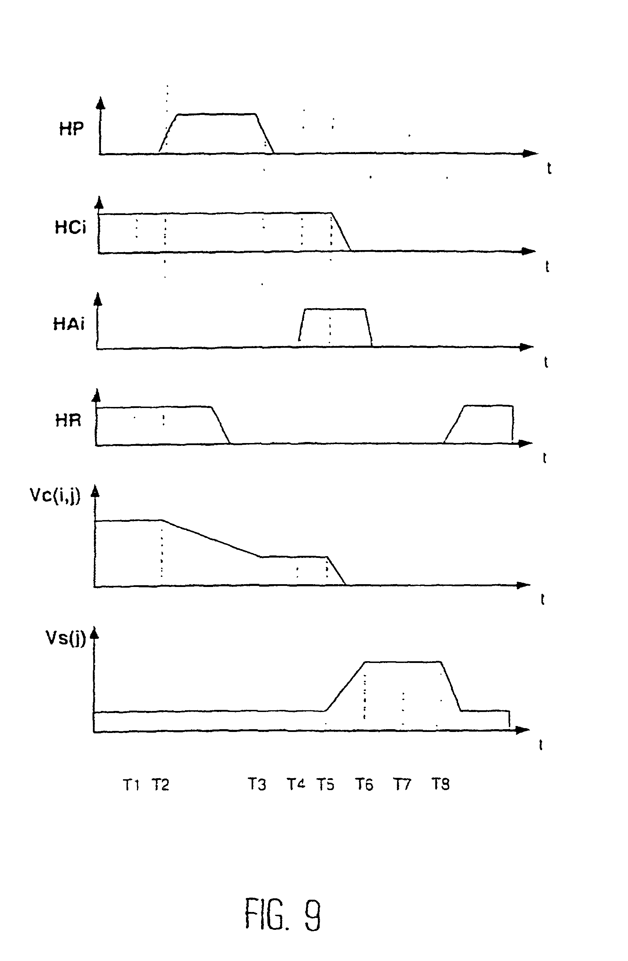

Pour une description du fonctionnement du circuit de lecture, le séquencement des horloges est illustré sur la figure 9.

A l'instant t = T1 :

- les horloges HCi, pour i = 1 à N, autrement dit toutes les grilles des transistors MOS Tc de la mosaïque, sont à l'état haut ;
- l'horloge HP est supposée à l'état bas, en conséquence de quoi aucun courant ne rentre dans le point élémentaire ;
- les horloges Hai sont supposées être à l'état bas ;
- l'horloge HR est telle que Ca soit court-circuitée.

A l'instant t = T2 :

- l'horloge HP passe à l'état haut, ce qui polarise convenablement le détecteur ;
- le détecteur délivre un courant qui est intégré dans le canal d'inversion du transistor NMOS Tc ;
- la tension Vc(i,j) aux bornes du condensateur d'intégration diminue en fonction du temps.

A l'instant t = T3 :

- l'horloge HP passe à l'état bas, ce qui stoppe l'intégration ;
- le temps de pose est donc égal à T3 - T2 ;
- il est identique et synchrone pour tous les points élémentaires ;
- il est alors possible de procéder à la lecture des charges stockées dans les points élémentaires ligne après ligne.

A l'instant t = T4 :

- l'horloge HAi de la ligne considérée passe à l'état haut.

A l'instant t = T5 :

- l'horloge HCi passe à l'état bas à l'instant T5, son taux de variation par unité de temps étant adapté à la bande passante de l'amplificateur de charges ;
- les charges stockées dans le point élémentaire PEL(i,j) sont alors injectées dans l'amplificateur de charges connecté à l'extrémité du bus colonne BCj ;
- la tension de sortie, Vs(j), de l'amplificateur de charge Acj augmente.

A l'instant t = T6 :

- l'horloge HAi passe à l'état bas ;
- le bus colonne est à haute impédance.

A l'instant t = T7 :

- le signal de sortie de l'amplificateur de charge Acj est établi ;
- ce signal est multiplexé vers l'amplificateur de sortie pour être traité.

A l'instant t = T8 :

- l'amplificateur de charges est réinitialisé ;
- la lecture de la ligne suivante peut commencer.

Avantages particuliers

**Prise de vues**

La solution proposée permet d'avoir un temps de pose de même durée et synchrone pour tous les points élémentaires, ce qui n'est pas le cas des solutions à intégration déportée.

**Rendement technologique, densité d'intégration, signal/bruit**

La possibilité de concevoir un point élémentaire avec les caractéristiques suivantes :

- un nombre limité de transistors MOS ;
- des transistors MOS de même type ;
- les charges stockées dans le canal d'un transistor MOS améliore de manière significative le rendement technologique car le nombre de contacts et d'interconnexions dans le point élémentaire diminue de manière significative pour les raisons suivantes :

  - il n'est pas nécessaire d'interconnecter les drain et source de certains transistors MOS de même type à l'aide de prises de contact et d'interconnexions métalliques car ceci peut être réalisé au moyen des diffusions utilisées pour réaliser les diodes de source et drain ;
  - il n'est pas nécessaire de respecter les règles de "latch-up", c'est-à-dire de connecter le substrat à l'alimentation Vss et le caisson à l'alimentation Vdd au moyen de contacts et interconnexions métalliques diverses car il n'est pas obligatoire d'implanter des transistors MOS complémentaires dans le point élémentaire ;
  - il n'est pas nécessaire de respecter les règles d'espacement entre transistors NMOS et PMOS dans le point élémentaire, car il n'est pas obligatoire d'implanter des transistors MOS complémentaires dans le point élémentaire ;
  - il n'est pas nécessaire d'implanter un dispositif de remise à zéro dans le point élémentaire.

Ces mêmes arguments techniques montrent que le taux de remplissage du point élémentaire de la solution proposée est supérieur ou égal à celui des autres solutions où le courant est intégré dans le point élémentaire. Pratiquement, la surface du condensateur de stockage qu'il est possible de dessiner dans le point élémentaire de la solution proposée est supérieure (dans des applications à pas réduit, la surface de stockage est au moins multipliée par un facteur deux) à celle qu'il serait possible de dessiner dans une architecture de type DTC ou bien à suiveurs commutés car le nombre de transistors MOS à y implanter est plus petit. Enfin, on peut montrer que l'excursion de potentiel dans le transistor MOS de stockage est supérieure à celle obtenue dans un point élémentaire de type suiveur commuté.

Par voie de conséquence, la charge stockable de la solution proposée, donc le rapport signal sur bruit du circuit, est supérieure à celle qu'il est possible d'atteindre en employant les solutions de l'art antérieur, toutes conditions opérationnelles (par exemple de taille, de pas des points élémentaires, de température, etc..) étant égales par ailleurs.

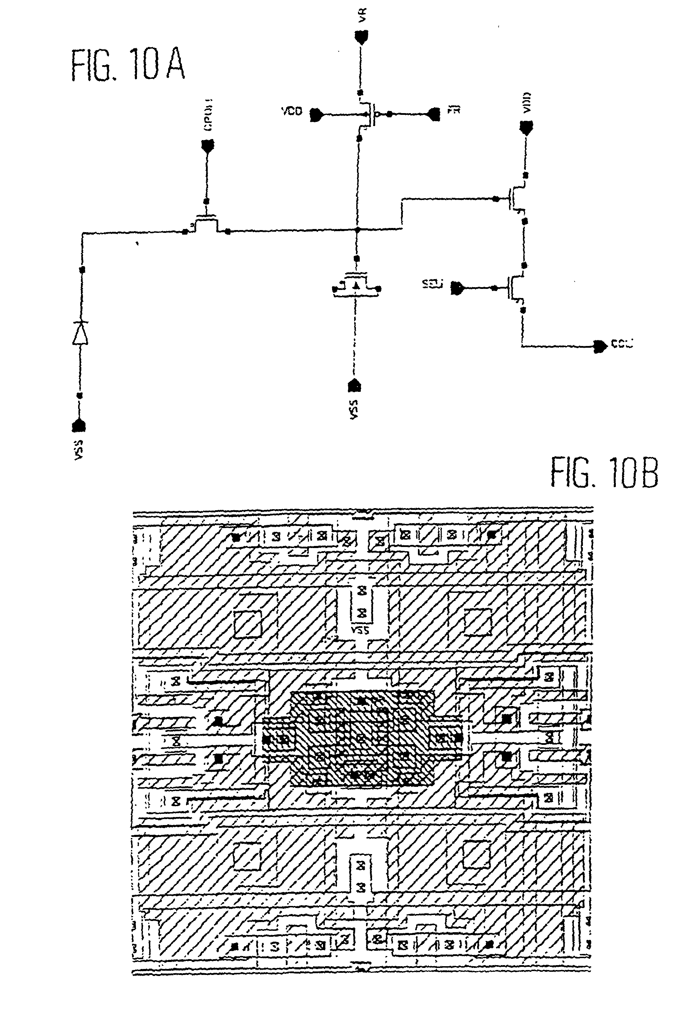

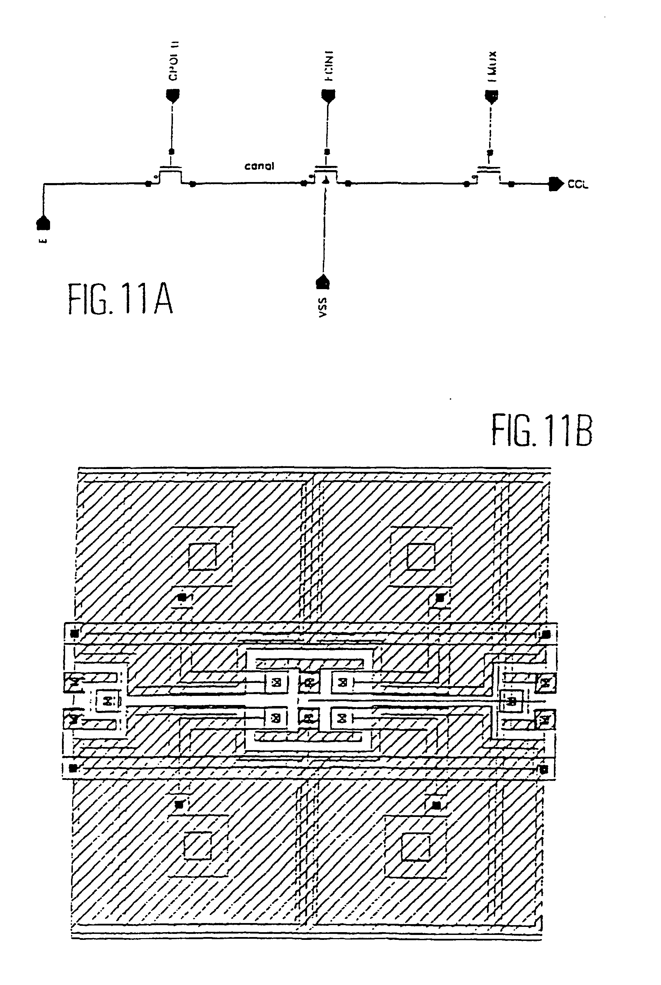

Ceci est illustré sur les figures 10A et 10B, et 11A et 11B, où une mosaïque de deux lignes par deux colonnes de points élémentaires de type suiveur commuté est comparée respectivement à une mosaïque de même format de points élémentaires de type SCA. Les schémas électriques des deux points élémentaires sont représentés au-dessus de l'implantation de ces motifs. Ces deux implantations montrent clairement, à règles de dessin constantes, que celle de l'architecture SCA est nettement plus simple que celle du suiveur commuté. L'homme de l'art y constate en particulier que la solution SCA est nettement supérieure à la solution de type suiveur commuté en terme de :

- densité d'interconnexion ;
- de nombre de contacts ;
- taux de remplissage (surface active/surface du point élémentaire).

## Linéarité

La charge intégrée dans le point élémentaire est convertie en tension par l'amplificateur de charges. La linéarité est donc contrôlée pour la plus grande partie par le coefficient de tension de la capacité du condensateur de contre-réaction de l'amplificateur de charges.

Ce type de condensateurs spécifiques est disponible dans les filières développées pour réaliser des circuits de type capacité commutée.

La fonction de transfert de la solution proposée est donc bien plus linéaire que :

- les circuits de type DTC dont l'efficacité de transfert, c'est-à-dire l'atténuation entrée-sortie, dépend du nombre de transfert et/ou de la charge à transférer ;
- les circuits de type suiveurs commutés dont le gain en tension n'est pas constant de point à point et/ou sur toute leur excursion d'entrée ;
- les circuits de type partition bus colonne où la capacité du bus colonne présente un coefficient de tension élevé à cause de la capacité des diodes des interrupteurs qui lui sont connectés qui varie avec la quantité de charges lues.

## Réjection des alimentations et des phases de commande

La solution proposée est nettement supérieure à celle des suiveurs commutés car il n'y a plus d'alimentation critique dans le point élémentaire, aussi bien au niveau de la réinitialisation du point élémentaire, que des alimentations du suiveur.

Par ailleurs, le potentiel de chaque bus colonne est maintenu constant par l'amplificateur de charges alors que dans les circuits de type suiveurs commutés ou partition sur bus colonne, ce potentiel varie énormément. Cette caractéristique limite les couplages capacitifs entre les différentes fonctions implantées dans le point élémentaire. Ce point est très important car la plupart des noeuds électriques du point élémentaire sont à haute impédance, donc très sensibles, et que ces couplages vont augmenter lorsque le pas des détecteurs va diminuer.

Enfin, il est important de noter que dans une architecture SCA, les condensateurs de stockage sont réinitialisés ligne après ligne, et non pas simultanément comme dans d'autres solutions, ce qui a pour effet de minimiser les appels de courant dans les alimentations, et par voie de conséquence de relâcher les contraintes sur les résistances des bus d'alimentation.

## Dispersions spatiales

Dans la solution proposée, les dispersions des paramètres de la technologie ne sont pas critiques dans le point élémentaire. Il suffit que la charge stockable dans le condensateur de stockage soit suffisamment grande.

Les dispersions spatiales sont essentiellement contrôlées par le coefficient de conversion des amplificateurs de charges. Il n'y a donc pas de dispersions le long d'une même colonne.

## Lecture/écriture

Les connexions, les interrupteurs et la logique de commande de cette architecture assurent une continuité électrique, c'est-à-dire une connexion de résistance finie, entre les point élémentaires d'une même colonne et les extrémités du bus de la colonne considérée.

Elles permettent donc, non seulement de lire l'information stockée dans les points élémentaires, mais aussi d'adresser individuellement ces points élémentaires afin d'y injecter un courant et/ou une tension. Autrement dit, par comparaison aux mémoires digitales, cette architecture est de type lecture-écriture et non pas lecture uniquement.

Le mode écriture est utilisable en l'occurrence pour contrôler certains opérateurs implantés dans le point élémentaire de façon à modifier la fonction de transfert de chaque point élémentaire, indépendamment les uns des autres, et ce de manière adaptative en cours de fonctionnement, si besoin est.

On peut prendre comme exemple d'application un circuit de lecture dit à "ébasage en courant" (brevet n° 88 10375 : système de détection d'informations sous forme de rayonnement électromagnétique et de lecture des informations détectées). Dans ce type de circuit, un courant est soustrait à celui de chaque détecteur avant intégration dans le point élémentaire, ce qui permet de minimiser la charge à stocker. Cette soustraction est réalisée au moyen d'un transistor MOS opérant en régime de saturation. Pratiquement, le courant ébasé dans chaque point élémentaire est réglé en présentant une scène uniforme devant le détecteur. Cette calibration opioétectrique pourrait être remplacée par une calibration purement électrique grâce au mode d'écriture.

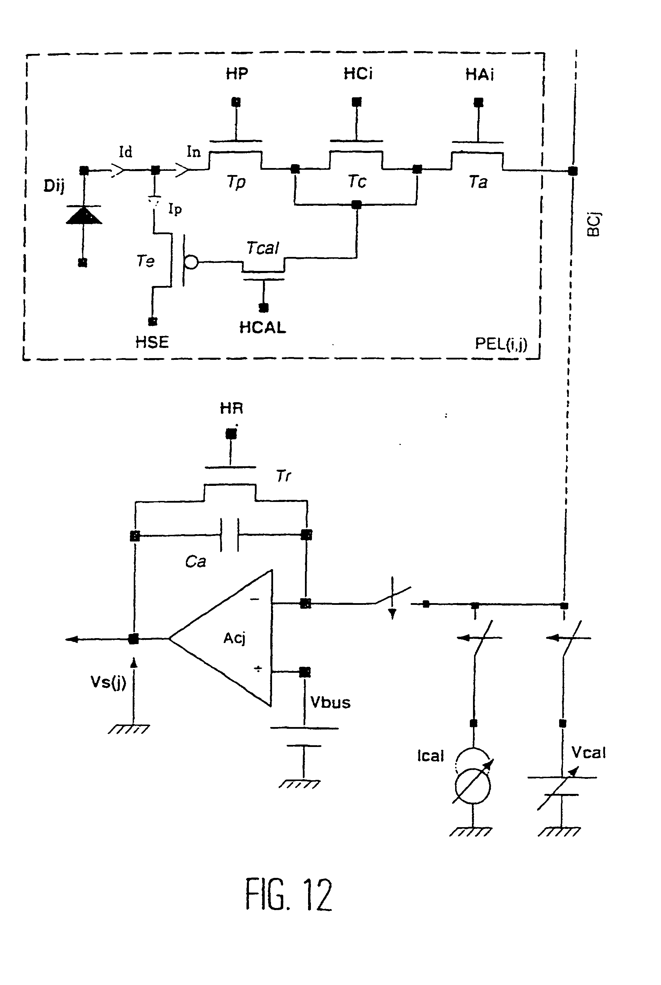

En effet, l'architecture proposée permet d'injecter soit un courant , soit une tension dans chaque point élémentaire. Ceci est illustré sur la figure 12. Le générateur de courant variable (Ical), ou bien la source de tension variable (Vcal), sont commutés sur les bus colonnes au moyen d'un démultiplexeur convenablement séquencé. Le courant ébasé par le transistor PMOS Te intégré dans le point élémentaire pourrait donc être réglé soit en recopiant Ical dans Te par des techniques de miroir de courant ou autres, soit en échantillonnant-bloquant sur la grille de Te une tension Vcal telle que le courant ébasé soit égal à la valeur voulue.

On conçoit alors qu'il est possible de procéder à des calibrations du circuit en venant modifier, selon les besoins de l'application et de manière indépendante pour chaque point élémentaire, l'intensité du courant ébasé. Les potentialités d'un tel type de calibration sont :

- diminution, voire suppression des prises de références optoélectriques ;
- réglage du courant ébasé dans chaque point élémentaire en fonction de l'évolution de l'éclairement reçu par le circuit de détection.

La testabilité des circuits de lecture dessinés dans un pas réduit, qui est souvent limitée car l'introduction d'un transistor MOS spécifique, se fait au détriment de la charge stockable, donc de la performance de la caméra.

Dans le cadre d'une architecture de type SCA, il apparaît sur la figure 12 qu'il est possible d'injecter dans le point élémentaire une tension et/ou un courant, ce qui résout le problème. Il est fort possible qu'il soit alors nécessaire de modifier le niveau haut appliqué à la grille du transistor MOS d'adressage, mais cela est facilement réalisable par l'homme de l'art.

**Multi-application**

Dans ce qui précède, on a traité le cas d'un détecteur apte à traiter une seule gamme de longueur d'onde.

Pour traiter des longueurs d'ondes dans des gammes différentes, il suffit d'avoir un détecteur par gamme de longueurs d'onde. Les courants fournis par ces différents détecteurs sont alors par nature différents.

Du fait que le transistor MOS situé dans le point élémentaire sert de réservoir, il est clair qu'il suffit de le dimensionner pour le courant détecté le plus grand pour avoir un circuit compatible avec plusieurs applications.

En effet, il suffit de concevoir un amplificateur de charges avec plusieurs capacités de contre-réaction pour obtenir un circuit qui présente une sensibilité optimum.

Ensuite il n'est pas nécessaire de modifier les caractéristiques électriques de l'amplificateur différentiel, comme sa bande passante, pour des applications légèrement différentes car il est possible de régler l'intensité du courant injecté dans le bus colonne, au moyen du taux de variation du temps de descente de l'horloge HCi. Il est donc possible de faire fonctionner l'amplificateur de charges à taux de variation du signal de sortie constant alors que le courant débité par le détecteur peut varier dans une très large gamme.

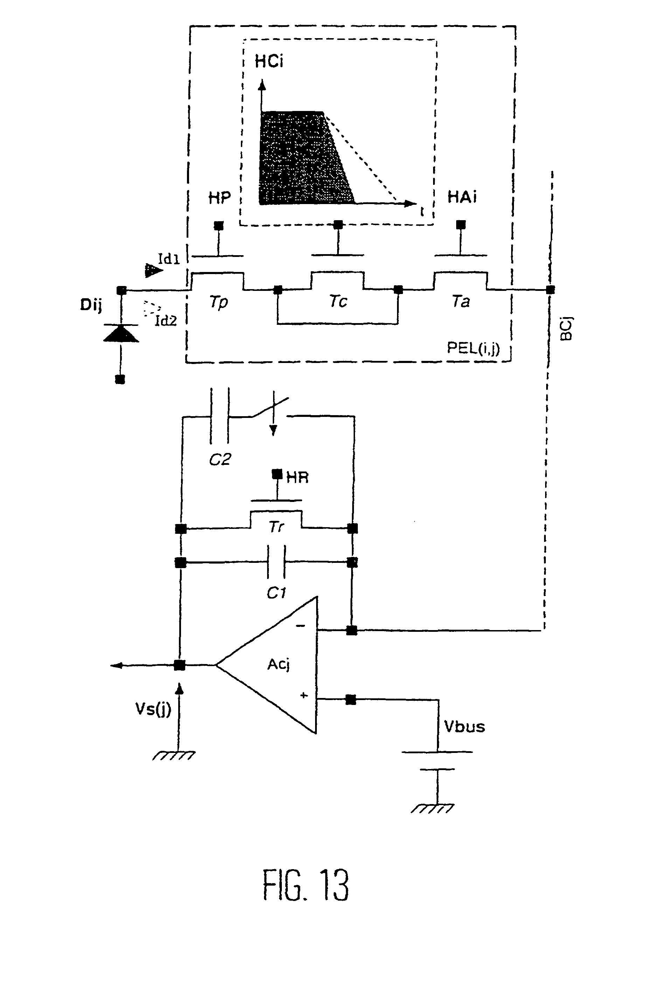

Le schéma de principe d'un tel circuit est représenté sur la figure 13. Le condensateur C2 peut être mis en parallèle sur le condensateur C1 en fermant l'interrupteur HCAL, ce qui permet d'avoir deux calibres de conversion charge-tension. Quant à l'horloge HC, il est facile d'en modifier le taux de variation du front de descente, soit en utilisant un générateur de signaux extérieur réglable, soit en la générant sur le circuit de lecture au moyen des techniques connues de l'homme de l'art.

Il s'avère donc que l'architecture de type SCA est versatile. Ce n'est pas le cas des solutions de type dispositifs à transfert de charges et des solutions à partition sur le bus colonne qui doivent toujours être utilisées avec le même niveau de charges. Ce n'est pas le cas non plus des suiveurs commutés, car bien qu'il soit potentiellement possible d'implanter plusieurs condensateurs dans ce type de point élémentaire, il s'avère que ceci n'est généralement pas réalisable pour cause de manque de place.

**Barrettes balayées à lecture TDI**

Il existe une catégorie de caméras où l'image est formée en balayant optiquement une mosaïque de détecteurs. Le nombre de lignes de cette mosaïque est fonction du format de l'image et son nombre de colonnes est tel qu'il permette d'améliorer le rapport signal sur bruit de la caméra. Ceci est obtenu en sommant à des instants retardés et synchrones (ce mode de lecture des informations est désigné par "Time Delay Integration" dans la littérature anglaise) du balayage optique les informations délivrées par les détecteurs d'une même ligne de mosaïque.

L'architecture de type SCA est une solution potentielle au problème de lecture de ce type de mosaïque, surtout lorsque le nombre de colonnes et le pas des détecteurs sont petits.

En effet, dans un circuit de lecture de ce type, le courant des détecteurs est tout d'abord transformé en charge, dans le pas des détecteurs si nécessaire.

Il est alors possible, en séquençant convenablement les horloges connectées aux grilles des condensateurs de stockage de lire les charges stockées dans les points élémentaires d'une ligne en les injectant successivement, c'est-à-dire colonne après colonne, sur un même bus ligne.

L'effet TDI est finalement obtenu en multiplexant judicieusement ces impulsions de courant vers des intégrateurs. Ces derniers convertissent l'impulsion de courant en charge et somment cette charge à la charge précédemment intégrée. Ils délivrent donc en sortie une tension proportionnelle à la somme des courants débités par les détecteurs de la ligne à des instants décalés.

Le nombre des intégrateurs et leur fréquence de réinitiafisation est fonction du nombre de colonnes et d'autres caractéristiques de la caméra.

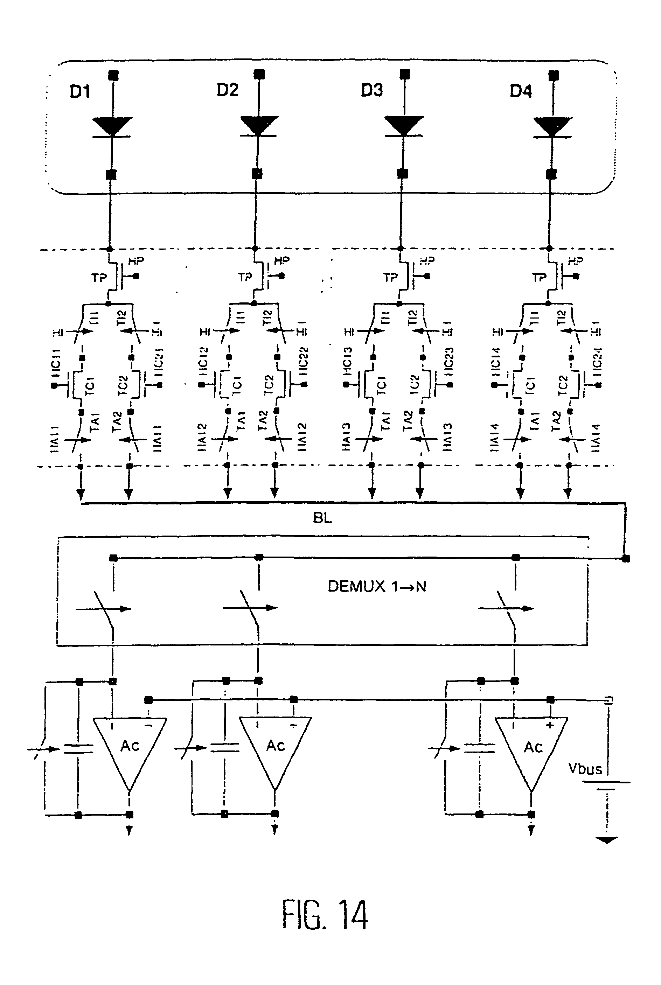

Le schéma de principe d'un circuit de lecture de type TDI en architecture SCA est donné sur la figure 14. On y suppose qu'il faut réaliser la lecture TDI d'une ligne de quatre détecteurs photovoltaïques (D1 à D4).

Chacun des quatre détecteurs est couplé au circuit de lecture en injection directe au moyen d'un transistor Tp. Le drain de Tp est connecté à deux condensateurs d'intégration TC1 et TC2 via deux interrupteurs TI1 et TI2. Les diodes source-drain de TC1 (respectivement TC2) sont connectées au bus ligne via un interrupteur TA1 (respectivement TA2). Une extrémité du bus ligne est connectée à l'entrée d'un démultiplexeur dont les sorties sont connectées aux N amplificateurs de charges Ac nécessaires à l'application envisagée.

Ce circuit fonctionne de la manière suivante. A chaque temps de pose, afin de ne pas perdre d'informations, le courant délivré par les détecteurs est intégré alternativement dans TC1 puis dans TC2 en séquençant convenablement les interrupteurs TI1 et TI2. Ceci permet de procéder à la lecture des charges stockées dans les condensateurs TC1 pendant que l'image suivante est intégrée dans TC2.

Ainsi un intervalle de temps égal au temps de pose est disponible pour multiplexer les charges stockées dans les quatre condensateurs TC1 sur le bus ligne, et démultiplexer les impulsions courants, induites sur le bus ligne par l'injection de ces charges, vers les amplificateurs de charges, de façon à synthétiser la fonction de transfert de sommation retardée.

La plupart des circuits de lecture de type TDI sont réalisés en filière CCD ("Charge-Coupled Device"). Ils donnent des résultats satisfaisants, mais la disponibilité de ces filières et leurs densités d'intégration pose des problèmes, surtout si l'on veut réaliser un TDI sur un grand nombre de colonnes et dans un faible pas.

Il existe des circuits de type TDI réalisés en filière CMOS, mais dans la plupart des cas il s'avère nécessaire d'y convertir la charge stockée dans le point élémentaire en tension de façon à pouvoir la multiplexer sur un bus ligne et de pouvoir sommer cette tension aux échantillons précédents par des intégrateurs, réalisés dans des techniques qui s'apparentent à celles des capacités commutées. Ce type de chaîne de traitement analogique est donc moins performant que celle d'une architecture de type SCA en terme d'encombrement, de consommation et de linéarité car elle nécessite plus de fonctions analogiques critiques.

Les circuits de lecture de type barrettes balayées à lecture TDI réalisés en filière CCD et ceux réalisés dans des architectures classiques en CMOS souffrent donc des mêmes limitations que leurs homologues conçus pour lire les mosaïques de détecteurs non balayées.

Les circuits de lecture de type TDI font donc partie du domaine d'application de l'architecture SCA pour les mêmes raisons que les circuits de lecture précédemment exposés.

Applications industrielles

Une application potentielle du type d'architecture proposée est la réalisation de circuits adaptés à la lecture de l'information délivrées par des détecteurs quantiques et des détecteurs bolométriques résistifs agencés de manière matricielle, essentiellement quand l'utilisation requiert un temps de pose identique et synchrone pour l'ensemble des détecteurs.

De par son concept, ce circuit est particulièrement polyvalent. Autrement dit, un même circuit de lecture peut être utilisé pour des applications relativement différentes, ce qui diminue le coût de développement et le coût de production.

Ce type de circuit de lecture ne nécessite pas de filière spécifique. Bien au contraire, il s'appuie sur les filières analogiques développées pour le traitement du signal.

L'augmentation du taux de remplissage du point élémentaire permet de développer en utilisant des filières couramment utilisées, des imageurs plus performants en terme de :

- charge stockable, à pas donné ;
- fonctions supplémentaires (on peut citer comme exemples de fonctions l'ébasage en courant, la diminution de l'impédance d'entrèe, l'augmentation de la bande passante d'entrée. Les dispositifs à implanter pour synthétiser ces fonctions sont connus de l'homme de l'art) implantées dans le point élémentaire, à charge stockable et à pas donné ;
- pas réduit, à charge stockable donnée.

L'architecture proposée est compatible avec un adressage aléatoire-des points élémentaires. Elle permet

## EP 0 883 900 B1

donc de réaliser une/des sous-images à l'intérieur de l'image. Il est clair que vu la versatilité du circuit, il permet de modifier le temps de pose et/ou la fréquence de sortie des sous-images, tout en conservant un rapport signal sur bruit optimum.

Dans certaines applications, les caméras peuvent faire de l'objet de contre-mesure comme un éblouissement par laser. Dans le cas d'une agression par un laser pulsé, l'architecture SCA peut être utilisée comme contrecontre-mesure en utilisant le fait qu'elle peut s'accommoder très facilement de deux temps de pose très différents, tout en conservant sa sensibilité. En effet, en changeant de manière plus ou moins aléatoire le temps de pose sur le circuit de lecture, il est possible de continuer à voir la cible entre deux impulsions. Ceci peut être envisagé avec l'architecture proposée car il suffit de dimensionner le condensateur de stockage pire-cas et les calibres des amplificateurs de charges de façon à ce qu'ils compensent les variations du temps de pose.

Enfin, ce circuit apporte une solution à la lecture des circuits de détection de type multicolore. En effet, les détecteurs de ces circuits présentent la particularité de délivrer un courant différent selon la gamme spectrale qu'ils détectent. Il est alors clair qu'il suffit d'avoir autant de transistors MOS dans le point élémentaire convenablement séquences et deux calibres différents sur l'amplificateur de charges que de gammes de longueurs d'onde détectées pour avoir un circuit de lecture dont le rapport signal sur bruit est optimum dans les différentes spectrales. Le schéma de principe d'un tel circuit est celui de la figure 13.

REFERENCES

[1] "256 x 256 PACE-1 PV HgCdTe focal plane arrays for medium and short wavelength infrared applications" de L.J. Kozlowski, K. Vural, V.H. Johnson, J.K. Chen, R.B. Bailey et D. Bui ; et de M.J. Gubala et J.R. Teague (SPIE vol. 1308 Infrared Detectors and Focal Plane Arrays, 1990).

[2] "Status and direction of PACE-I HgCdTe FPAs for astronomy" de L.J. Kozlowski, K. Vural, D.Q. Bui, R.B. Bailey, D.E. Cooper et D.M. Stephenson (SPIE Vol. 1946 Infrared Detectors and instrumentation, 1993).

[3] "Evaluation of the SBRC 256 x 256 InSb focal plane array and preliminary specifications for the 1024 x 1024 InSb focal plane array" de A.M. Fowler et J. Heynssens (SPIE Vol. 1946 Infrared Detectors and Instrumentation, 1993)

[4] "p-channel MIS double-métal process InSb monolithic unit cell for infra-red imaging" de A. Kepten, Y. Shacham-Diamand et S.E. Schacham (SPIE Vol. 1685 Infrared Detectors and Focal Plane Arrays II, 1992)

[5] "Practical design considerations in achieving high performance from infrared hybrid focal plane arrays" de R. A. Ballingall et I.D. Blenkinsop ; et de I.M. Baker et J. Parsons (SPIE Vol. 819 Infrared Technology XIII, 1987).

[6] "High-performance 5-μm 640 x 480 HgCdTe-on-sapphire focal plane arrays" de L.J. Kozlowski, R.B. Bailey, S. A. Cabelli, D.E. Cooper, I.S. Gergis, A. Chi-yi Chen, W.V. McLevige, G.L. Bostrup, K. Vural, W.E. Tonnant, et de P.E. Howard (Optical Engineering 33(1), 54-63, Janvier 1994)

[7] US-A-5,184,018

[8] "Proceedings of the International Electron Devices Meeting", Washington, Dec. 5-8, 1993, 5 décembre 1993, Institute of Electrical and Electronics Engineers, pages 583-586, XP000481685 Mendis K. et al. : "128 X 128 CMOS active pixel image sensor for highly integrated imaging systems".

[9] US-A-4,942,474

[10] Japanese journal of applied physics, vol. 32, n°1A, PART 01, 1 janvier 1993, pages 198-204, XP000413975 Fujieda I. et al. : "High sensitivity readout of 2D A-Si image sensors".

[11] Proceedings of the conference of electrical and electronics engineers in Israel, Tel Aviv, Mar. 7-9, 1989, n° conf. 16, 7 mars 1989, Institute of electrical and electronics engineers, pages 1-4, XP000077575 Kepten A. et al. : "InSb monolithic unit cell for IR imaging".

**Revendications**

1. Dispositif de lecture d'une matrice de détecteurs photoniques, qui délivre un courant dont l'intensité varie en fonction du flux incident, le temps de pose étant identique et synchrone pour tous les détecteurs, qui comprend :

   - un ensemble de points élémentaires (PEL(i,j)) permettant de lire les signaux délivrés par chaque détecteur,
   - plusieurs amplificateurs de charges (ACj) connectés chacun à l'extrémité d'un bus colonne (BCj),
   - au moins un amplificateur de sortie, le multiplexage des sorties des amplificateurs de charge vers les entrées de cet au moins un amplificateur de sortie se faisant au moyen d'interrupteurs, chaque point élémentaire comprenant:

     • un détecteur (DET (i;j)), un dispositif d'adressage (Ta),**caractérisé en ce que** chaque point élémentaire comprend :

       • un dispositif d'intégration et de stockage (Cpel),
       • un dispositif d'adaptation d'impédance (AI) disposé entre ce détecteur et de dispositif d'adaptation et de stockage,
       • le dispositif d'adressage (Ta) étant apte à commuter la sortie du dispositif d'intégration et de stockage sur un bus colonne (BCj) commun à tous les points élémentaires d'une même colonne.

2. Dispositif selon la revendication 1, **caractérisé en ce que** les détecteurs photoniques sont des détecteurs quantiques.

3. Dispositif selon la revendication 1, **caractérisé en ce que** les détecteurs photoniques sont des détecteurs thermiques.

4. Dispositif selon la revendication 1, **caractérisé en ce que** les détecteurs sont réalisés sur un autre substrat que ledit dispositif de lecture.

5. Dispositif selon la revendication 1, **caractérisé en ce que** les détecteurs sont réalisés directement sur le circuit du dispositif de lecture.

6. Dispositif selon la revendication 1, **caractérisé en ce que** le dispositif d'adaptation d'impédance est situé entre le détecteur considéré et le dispositif d'intégration, de stockage et d'évacuation de charge.

7. Dispositif selon la revendication 6, **caractérisé en ce que** le dispositif d'intégration, de stockage et d'évacuation de charge est réalisé au moyen d'au moins un transistor MOS dont la source et le drain sont connectés au détecteur via un interrupteur et dont la grille est pilotée par une horloge.

8. Dispositif selon la revendication 7, **caractérisé en ce que** le dispositif d'adressage permet de commuter la source et/ou le drain du transistor MOS sur une connexion commune aux points élémentaires d'une même colonne, dite bus colonne.

9. Dispositif selon la revendication 7, **caractérisé en ce que** le dispositif d'adaptation d'impédance est un transistor MOS (Tp).

10. Dispositif selon la revendication 9, **caractérisé en ce que** l'interrupteur comporte un transistor dont le niveau analogique haut de commande de la grille est légèrement supérieur à la tension de seuil.

11. Dispositif selon la revendication 9, **caractérisé en ce que** le dispositif d'adaptation d'impédance est un transistor MOS (Ta).

12. Dispositif selon la revendication 1, **caractérisé en ce que** chaque amplificateur de charges a un temps d'établissement inférieur au temps de descente de l'horloge.

13. Dispositif selon la revendication 1, **caractérisé en ce que** le nombre de lignes est égal à 1 (i=1) et **en ce qu'**il n'y a pas de connexion commune et **en ce qu'**il y a autant d'amplificateurs de charges que de lignes dans la barrette, le multiplexage étant limité au multiplexage des amplificateurs de charges.

**14.** Dispositif selon la revendication 1, **caractérisé en ce que** l'amplificateur de charges (Ac) comprend :

- un préamplificateur d'entrée ;
- un condensateur de contre-réaction dont la capacité est égale à la charge maximum à lire divisée par l'excursion de tension de sortie de l'amplificateur ;
- un amplificateur différentiel dont le produit gain x bande est adapté au temps de montée de l'impulsion de courant qui est injectée dans le bus.

**15.** Dispositif selon la revendication 10, **caractérisé en ce que**

- le dispositif d'adaptation d'impédance est muni d'une première horloge, apte à polariser le détecteur correspondant et à lire le courant fourni par ce détecteur ;
- chaque transistor MOS est muni d'une seconde horloge apte d'une part à intégrer le courant fourni par le détecteur et d'autre part, associé à un dispositif d'adressage, à stocker la charge obtenue ;
- le dispositif d'adressage, comprenant des bus lignes et des bus colonnes, est muni d'une troisième horloge, apte à commuter la source et/ou le drain du transistor MOS sur une connexion commune des points élémentaires d'une même colonne ;
- l'amplificateur de charge est apte à lire la charge de façon synchrone pour chaque ligne, les lignes étant lues les unes après les autres.

**16.** Dispositif selon la revendication 15, **caractérisé en ce que**

- le dispositif d'adaptation d'impédance est relié par sa source au détecteur, par son drain à la source et/ou au drain du transistor MOS et par sa grille à la première horloge qui commute entre la masse et une tension de polarisation ;
- la grille du transistor MOS est reliée à la seconde horloge qui commute entre la masse et une tension et qui permet l'évacuation de la charge stockée sur une connexion commune ;
- le dispositif d'adressage est relié, par sa source à la connexion vacante (source ou drain) du transistor MOS, par son drain au bus colonne et par sa grille à la troisième horloge qui commute la grille entre la masse et Vécran ;
- l'amplificateur de charges est connecté au dispositif d'adressage, au bus colonne et au suiveur vidéo.

**17.** Procédé de lecture d'une matrice de détecteurs photoniques comprenant un dispositif de lecture selon la revendication 1, qui délivre un courant dont l'intensité varie en fonction du flux incident, le procédé comprenant les étapes suivantes :

- polarisation du détecteur et conversion du courant du détecteur en charge par intégration d'une durée égale au temps de pose ;
- conversion de la charge intégrée en une impulsion de courant dont l'amplitude est ajustable en fonction d'un stimulus et dont la durée varie en fonction de la charge stockée ;
- conversion de cette impulsion de courant en tension au moyen d'un amplificateur contre-réactionné par une capacité ;
- une fois par image, intégration du courant fourni par le détecteur dans un dispositif de stockage pendant un temps prédéfini en fonction des conditions d'éclairement de la scène, des caractéristiques du détecteur, de la valeur de la capacité de stockage ;
- évacuation des charges réalisée pour chaque ligne de la matrice ;
- lorsque l'on a balayé toutes les lignes, on recommence les étapes précédentes pour une autre image.

**Patentansprüche**

**1.** Vorrichtung zum Ablesen einer Photonendetektoren-Matrix, die einen Strom liefert, dessen Intensität in Abhängigkeit von dem eintreffenden Lichtstrom variiert, wobei die Belichtungszeit für alle Detektoren identisch und synchron ist, die umfasst:

- eine Gruppe von Elementarpunkten (PEL(i, j)), die ermöglichen, die durch jeden Detektor gelieferten Signale zu lesen,
- mehrere Ladungsverstärker (ACj), jeder verbunden mit dem Ende eines Spaltenbusses (BCj),

- wenigstens einen Ausgangsverstärker, wobei das Multiplexen der Ausgänge der Ladungsverstärker auf die Eingänge dieses wenigstens einen Ausgangsverstärkers durch Schalter erfolgt und jeder Elementarpunkt umfasst:

  • einen Detektor (DET (i;j)), eine Adressiereinrichtung (Ta),

**dadurch gekennzeichnet, dass** jeder Elementarpunkt umfasst:

  • eine Integrations- und Speichereinrichtung (Cpel),
  • eine Impedanzadaptionseinrichtung (AI), angeordnet zwischen diesem Detektor und der Anpassungs- und Speichereinrichtung,
  • die Fähigkeit der Adressiereinrichtung (Ta), den Ausgang der Integrations- und Speichereinrichtung auf einen allen Elementarpunkten einer selben Spalte gemeinsamen Spaltenbus (BCj) zu schalten.

2. Vorrichtung nach Anspruch 1, **dadurch gekennzeichnet, dass** die Photonendetektoren Quantendetektoren sind.

3. Vorrichtung nach Anspruch 1, **dadurch gekennzeichnet, dass** die Photonendetektoren Wärmedetektoren sind.

4. Vorrichtung nach Anspruch 1, **dadurch gekennzeichnet, dass** die Detektoren auf einem anderen Substrat als die Ableseeinrichtung realisiert sind.

5. Vorrichtung nach Anspruch 1, **dadurch gekennzeichnet, dass** die Detektoren direkt auf der Schaltung der Ableseeinrichtung realisiert sind.

6. Vorrichtung nach Anspruch 1, **dadurch gekennzeichnet, dass** die Impedanzadaptionseinrichtung sich zwischen dem betreffenden Detektor und der Integrations-, Speicher- und Ladungsableitungseinrichtung befindet.

7. Vorrichtung nach Anspruch 6, **dadurch gekennzeichnet, dass** die Integrations-, Speicher- und Ladungsableitungseinrichtung mittels wenigstens eines MOS-Transistors realisiert wird, dessen Source und Drain mit dem Detektor durch einen Schalter verbunden sind und dessen Gate durch einen Takt gesteuert wird.

8. Vorrichtung nach Anspruch 7, **dadurch gekennzeichnet, dass** die Adressiereinrichtung ermöglicht, die Source und/oder den Drain des MOS-Transistors auf eine Spaltenbus genannte gemeinsame Verbindung der Elementarpunkte einer selben Spalte zu schalten.

9. Vorrichtung nach Anspruch 7, **dadurch gekennzeichnet, dass** die Impedanzadaptionseinrichtung ein MOS-Transistor (Tp) ist.

10. Vorrichtung nach Anspruch 9, **dadurch gekennzeichnet, dass** der Schalter einen Transistor umfasst, dessen analoger Hochpegel zur Steuerung des Gates etwas höher ist als die Schwellenspannung.

11. Vorrichtung nach Anspruch 9, **dadurch gekennzeichnet, dass** die Impedanzadaptionseinrichtung ein MOS-Transistor (Ta) ist.

12. Vorrichtung nach Anspruch 1, **dadurch gekennzeichnet, dass** jeder Ladungsverstärker eine Ansprechzeit hat, die kleiner bzw. kürzer ist als die Abfallzeit des Takts.

13. Vorrichtung nach Anspruch 1, **dadurch gekennzeichnet, dass** die Zeilenzahl gleich 1 ist (i=1), und dass es keine gemeinsame Verbindung gibt, und dass es ebenso viele Ladungsverstärker wie Zeilen in der Anordnung gibt, wobei das Multiplexing begrenzt ist auf das Multiptexing der Ladungsverstärker.

14. Vorrichtung nach Anspruch 1, **dadurch gekennzeichnet, dass** der Ladungsverstärker (Ac) umfasst:

- einen Eingangsvorverstärker;
- einen Rückkopplungskondensator, dessen Kapazität gleich der maximal zu lesenden Ladung, geteilt durch die Ausgangsspannungsexkursion des Verstärkers, ist;
- einen Differentialverstärker, dessen Produkt aus Verstärkung mal Band angepasst ist an die Anstiegszeit des in den Bus eingespeisten Stromimpulses.

**15.** Vorrichtung nach Anspruch 10, **dadurch gekennzeichnet:**

- **dass** die Impedanzadaptionseinrichtung einen ersten Takt aufweist, fähig den entsprechenden Detektor zu polen und den durch diesen Detektor gelieferten Strom zu lesen;
- **dass** jeder MOS-Detektor einen zweiten Takt aufweist, einerseits fähig, den durch den Detektor gelieferten Strom zu integrieren und andererseits, verbunden mit einer Adressiereinrichtung, die erhaltene Ladung zu speichern:

- **dass** die Adressiereinrichtung, Zeilenbusse und Spaltenbusse umfassend, einen dritten Takt aufweist, fähig die Source und/oder den Drain des MOS-Transistors auf eine gemeinsame Verbindung der Elementarteilchen einer selben Spalte zu schalten;
- **dass** der Ladungsverstärker fähig ist, in synchroner Weise die Ladung jeder Zeile zu lesen,

wobei die Zeilen nacheinander gelesen werden.

**16.** Vorrichtung nach Anspruch 15, **dadurch gekennzeichnet:**

- **dass** die Impedanzadaptionseinrichtung mit ihrer Source mit dem Detektor, mit ihrem Drain mit der Source und/oder dem Drain des MOS-Transistors und mit ihrem Gate mit dem ersten Takt verbunden ist, der umschaltet zwischen der Masse und einer Polungsspannung;
- **dass** das Gate des MOS-Transistors mit dem zweiten Takt verbunden ist, der umschaltet zwischen der Masse und einer Spannung und der die Ableitung der in einer gemeinsamen Verbindung gespeicherten Ladung ermöglicht;
- **dass** die Adressiereinrichtung mit ihrer Source mit dem freien Anschluss (Source oder Drain) des MOS-Transistors, mit ihrem Drain mit dem Spaltenbus und mit ihrem Gate mit dem dritten Takt verbunden ist, der das Gate umschaltet zwischen der Masse und Vécran;
- **dass** der Ladungsverstärker mit der Adressiereinrichtung, dem Spaltenbus und dem Videoverfolger verbunden ist.

**17.** Verfahren zum Ablesen einer eine Ablesevorrichtung nach Anspruch 1 umfassenden Photonendetektorenmatrix, die einen Strom liefert, dessen Intensität in Abhängigkeit von dem eintreffenden Lichtstrom variiert, wobei dieses Verfahren die folgenden Schritte umfasst:

- Polung des Detektors und Umwandlung des Stroms des Detektors in Ladung durch Integration mit einer Dauer gleich der Belichtungszeit;
- Umwandlung der integrierten Ladung in einen Stromimpuls, dessen Amplitude anpassbar ist in Abhängigkeit von einem Stimulus, und dessen Dauer variiert in Abhängigkeit von der gespeicherten Ladung;
- Umwandlung dieses Stromimpulses in Spannung mittels eines durch eine Kapazität rückgekoppelten Verstärkers;
- einmal pro Bild Integration des durch den Detektor während einer Zeit in einen Speicher gelieferten Stroms, die vorher festgelegt wird in Abhängigkeit von den Beleuchtungsbedingungen der Szene, der Charakteristika des Detektors, dem Wert der Speicherkapazität;
- Ableitung der für jede Zeile der Matrix realisierten Ladungen;
- nach Abtastung aller Zeilen Neubeginn bzw. Wiederholung der vorangehenden Schritt für ein weiteres Bild.

**Claims**

**1.** A device for reading a matrix of photon detectors supplying a current, whose intensity varies as a function of the incident flux, the exposure time being identical and synchronous for all the detectors and which comprises:

- a set of elementary points (PEL (ij)) making it possible to read the signals supplied by each detector,
- several charge amplifiers (ACj), each connected to the end of a column bus (BCj),
- at least one output amplifier, the multiplexing of the outputs of the charge amplifiers to the inputs of said at least one output amplifier taking place by means of switches, each elementary point comprising:

- a detector (DET (ij)), an addressing device (Ta), **characterized in that** each elementary point comprises:

- an integration and storage device (Cpel),
- an impedance matching device (AI) located between said detector and said integration and storage device,
- the addressing device (Ta) being able to switch the output of the integration and storage device to a column bus (BCj) common to all the elementary points of the same column.

2. A device according to claim 1, **characterized in that** the photon detectors are quantum detectors.

3. A device according to claim 1, **characterized in that** the photon detectors are thermal detectors.

4. A device according to claim 1, **characterized in that** the detectors are produced on a substrate other than the said reading device.

5. A device according to claim 1, **characterized in that** the detectors are produced directly on the circuit of the reading device.

6. A device according to claim 1, **characterized in that** the impedance matching device is situated between the detector under consideration and the charge integration, storage and discharge device.

7. A device according to claim 6, **characterized in that** the charge integration, storage and discharge device is implemented by means of at least one MOS transistor whose source and drain are connected to the detector via a switch and whose gate is controlled by a clock.

8. A device according to claim 7, **characterized in that** the addressing device enables the source and/or drain of the MOS transistor to be switched onto a connection common to the elementary points of one and the same column, referred to as a column bus.

9. A device according to claim 7, **characterized in that** the impedance matching device is a MOS transistor (Tp).

10. A device according to claim 9, **characterized in that** the switch incorporates a transistor, whose high gate control analog level slightly exceeds the threshold voltage.

11. A device according to claim 9, **characterized in that** the impedance matching device is a MOS transistor (Ta).

12. A device according to claim 1, **characterized in that** each charge amplifier has an establishment time lower than the fall time of the clock.

13. A device according to claim 1, **characterized in that** the number of lines is equal to 1 (i = 1) and **in that** there is no common connection and **in that** there are the same number of charge amplifiers as there are lines in the linear array, multiplexing being limited to the multiplexing of the charge amplifiers.

14. A device according to claim 1, **characterized in that** the charge amplifier (Ac) comprises:

- an input preamplifier;
- a feedback capacitor whose capacitance is equal to the maximum charge to be read divided by the output voltage excursion of the amplifier;
- a differential amplifier whose gain x band product is adapted to the rise time of the current pulse which is injected into the bus.

15. A device according to claim 10, **characterized in that**:

- the impedance matching device is provided with a first clock, able to bias the corresponding detector and to read the current supplied by this detector;
- each MOS transistor is provided with a second clock able on the one hand to integrate the current supplied by the detector and on the other hand, associated with an addressing device, to store the charge obtained;
- the addressing device, comprising line buses and column buses, is provided with a third clock, able to switch the source and/or drain of the MOS transistor onto a common connection of the elementary points of one and the same column;
- the charge amplifier is able to read the charge synchronously for each line, the lines being read one after the other.

**16.** A device according to claim 15, **characterized in that**:

- the impedance matching device is connected by its source to the detector, by its drain to the source and/or drain of the MOS transistor and by its gate to the first clock which switches between earth and a biasing voltage;
- the gate of the MOS transistor is connected to the second clock, which switches between earth and a voltage and which enables the stored charge to be discharged onto a common connection;
- the addressing device is connected, by its source, to the vacant connection (source or drain) of the MOS transistor, by its drain to the column bus and by its gate to the third clock, which switches the gate between earth and Vscreen;
- the charge amplifier is connected to the addressing device, to the column bus and to the video follower.

**17.** A method of reading a matrix of photon detectors comprising a reading device according to claim 1, which delivers a current whose intensity varies according to the incident flux, the method comprising the following steps:

- polarizing the detector and converting the current of the detector into a charge by integration of a duration equal to the exposure time;
- converting the integrated charge into a current pulse whose amplitude is adjustable according to a stimulus and whose duration varies according to the stored charge;
- converting this current pulse into a voltage by means of an amplifier with feedback through a capacitance;
- once per image, integrating the current supplied by the detector in a storage device for a time predefined according to the scene lighting conditions, the characteristics of the detector and the value of the storage capacitance;
- discharging the charges performed for each line of the matrix;
- when all the lines have been scanned, the preceding steps are recommenced for another image.

FIG. 1A

FIG. 1B

FIG. 2A

FIG. 2B

FIG. 3A

FIG. 3B

FIG. 4A

PEL(i,j)

DET(i,j)

AI

BCj

FIG. 4B

PEL (1,1)

PEL (1,M)

BC1

BCM

PEL (N,1)

PEL (N,M)

Ac

Ca

RAZ

Ac

Ca

RAZ

As

Vs

FIG. 5 A

FIG. 5 B

FIG. 6

Tp          Tc          Ta          BC

FIG. 7

FIG. 8

FIG. 9

FIG. 10 A

FIG. 10 B

FIG. 11A

FIG. 11B

FIG. 12

FIG. 13

FIG. 14